# EUROPEAN PATENT APPLICATION

(11) **EP 4 557 045 A1**
(43) Date of publication of application: **21.05.2025**
(21) Application number: 23860758.4
(22) Date of filing: 22.08.2023
(51) Int. Cl.: G06F 1/16, H04M 1/02, G06F 3/041, G06F 3/14

(54) **ELECTRONIC DEVICE COMPRISING FLEXIBLE DISPLAY, AND METHOD FOR REDUCING IMAGE QUALITY DEVIATION IN FLEXIBLE DISPLAY**

(30) Priority: 01.09.2022 KR 20220110843; 05.10.2022 KR 20220127355
(71) Applicant: Samsung Electronics Co., Ltd., Suwon-si, Gyeonggi-do 16677 (KR)
(72) Inventor: KIM, Junghyung, Suwon-si, Gyeonggi-do 16677 (KR); CHUN, Jaebong, Suwon-si, Gyeonggi-do 16677 (KR); KIM, Areum, Suwon-si, Gyeonggi-do 16677 (KR)
(74) Representative: Appleyard Lees IP LLP
(86) International application number: PCT/KR2023/012374
(87) International publication number: WO 2024/049080

(57) **Abstract**

One embodiment of the present disclosure relates to an electronic device comprising a flexible display, and a method for reducing image quality deviation in the flexible display. The electronic device comprises: a flexible display in which a visible area visible from the outside of the electronic device is reduced or extended; and a processor, wherein the processor: controls a driving circuit such that a first area of the flexible display forms a first visible area in a first reduced state; switches to an extended state in response to an extension trigger event, the extended state being a state in which the first area of the flexible display and a second area of the flexible display form a second visible area, and the second area being adjacent to the first area and disposed inside a housing during the first reduced state; and switches from the extended state to a second reduced state in response to a reduction trigger event, the second reduced state being a state in which the second area forms at least a part of a third visible area.

## Description

### [Technical Field]

An embodiment of the disclosure relates to an electronic device including a flexible display and a method for reducing image quality deviation in a flexible display.

### [Background Art]

Electronic devices are gradually evolving from a uniform rectangular shape into a variety of shapes. For example, research and development of electronic devices having rollable displays (or flexible displays) is actively underway.

Electronic devices are being researched and developed to have a form factor that allows the display to be folded, bent, rolled, or unfolded by applying a rollable display.

The above information may be provided as related art to aid in understanding of the disclosure. No assertion or determination is made as to the applicability of any of the foregoing as prior art in relation to the disclosure.

### [Disclosure of Invention]

### [Technical Problem]

An organic light emitting diode (OLED) may be applied to a rollable display. For example, a display panel of a rollable display may have flexible characteristics and pixels on the display panel may include OLEDs.

Display panels including OLEDs may experience a phenomenon known as burn-in, which leaves residual images or irregular brightness patterns on the screen. Bum-in on a display panel may be caused by deviations in the driving time (e.g., cumulative light-emission time) of OLEDs for a plurality of pixels.

In an electronic device including a flexible display (or a rollable display), a portion of the display may be inserted into or withdrawn from inside a housing in order to adjust the size of a visible region of the display. Accordingly, the electronic device including a flexible display (or a rollable display) may experience deviations in a display usage time corresponding to the inserted state or a display usage time corresponding to the withdrawn state, and the deviations may cause deviations in the image quality of the display.

An embodiment of the disclosure may provide an electronic device including a flexible display and a method for reducing image quality deviation in the flexible display.

The problems that the embodiments disclosed herein are intended to solve are not limited to those described above, and may be variously extended without departing from the idea and the scope disclosed herein.

### [Solution to Problem]

An embodiment of the present disclosure relates to an electronic device comprising a flexible display, and a method for reducing image quality deviation in the flexible display. The electronic device comprises: a flexible display in which a visible area visible from the outside of the electronic device is reduced or extended; and a processor, wherein the processor: controls a driving circuit such that a first area of the flexible display forms a first visible area in a first reduced state; switches to an extended state in response to an extension trigger event, the extended state being a state in which the first area of the flexible display and a second area of the flexible display form a second visible area, and the second area being adjacent to the first area and disposed inside a housing during the first reduced state; and switches from the extended state to a second reduced state in response to a reduction trigger event, the second reduced state being a state in which the second area forms at least a part of a third visible area.

An embodiment of the present disclosure relates to a method performed by an electronic device. The electronic device comprises: a first housing, a second housing disposed to slide with respect the first housing, a flexible display in which a visible region visible from outside the electronic device is reduced or extended based on slide-in or slide-out driving of the second housing and a driving unit configured to generate a driving force for sliding the second housing. The method comprises: controlling the driving unit such that a first region of the flexible display is shown as a first visible region in a first reduced state in which a portion of the second housing slides into the first housing, switching, in response to an extension trigger event, from the first reduced state to an extended state in which the portion of the second housing slides out from inside the first housing, the extended state being a state in which the first region of the flexible display and a second region of the flexible display are shown as a second visible region, and the second region being adjacent to the first region and disposed inside the second housing during the first reduced state and switching from the extended state to a second reduced state in response to a reduction trigger event, the second reduced state being a state in which the second region is shown as at least a portion of a third visible region..

### [Advantageous Effects of Invention]

The electronic device and the method according to an embodiment of the disclosure may reduce image quality deviation in a flexible display by adjusting the visible region of the display, which is withdrawn to the outside to display a screen, based on the degree of burn-in of the display.

The effects derived from embodiments disclosed herein are not limited to the effects described above, and may be variously extended without departing from the idea and the scope disclosed herein.

### [Brief Description of Drawings]

Other aspects, features and advantages according to specific embodiments of the present disclosure will become more apparent from the drawings and the description.
FIG. 1 is a block diagram illustrating an electronic device in a network environment according to various embodiments.
FIGS. 2A and 2B illustrate an electronic device having a sliding structure according to an embodiment.
FIGS. 3A and 3B illustrate an electronic device having a sliding structure according to an embodiment.
FIG. 4A is a cross-sectional view schematically illustrating a reduced state of an electronic device having a sliding structure according to an embodiment.
FIG. 4B is a conceptual view illustrating a flexible display in the reduced state of the electronic device according to an embodiment.
FIG. 5A is a cross-sectional view schematically illustrating an extended state of the electronic device having a sliding structure according to an embodiment.
FIG. 5B is a conceptual view illustrating the flexible display in the extended state of the electronic device according to an embodiment.
FIG. 6 is a graph depicting display data used to drive the flexible display when the electronic device according to an embodiment is in a reduced state.
FIG. 7A is a cross-sectional view schematically illustrating a first reduced state of an electronic device having a sliding structure according to an embodiment.
FIG. 7B is a conceptual view illustrating the flexible display in the first reduced state of the electronic device according to an embodiment.
FIG. 8A is a cross-sectional view schematically illustrating an extended state of an electronic device having a sliding structure according to an embodiment.
FIG. 8B is a conceptual diagram illustrating a flexible display in the extended state of the electronic device according to an embodiment.
FIG. 9A is a cross-sectional view schematically illustrating a second reduced state of an electronic device having a sliding structure according to an embodiment.
FIG. 9B is a conceptual view illustrating a flexible display in the second reduced state of the electronic device according to an embodiment.
FIG. 10 is a perspective view schematically illustrating a reduced state of an electronic device having a sliding structure according to an embodiment.
FIG. 11 is a perspective view schematically illustrating an extended state of the electronic device having a sliding structure according to an embodiment.
FIG. 12A is a cross-sectional view schematically illustrating a first reduced state of an electronic device having a sliding structure according to an embodiment.
FIG. 12B is a conceptual view illustrating a flexible display in the first reduced state of the electronic device according to an embodiment.
FIG. 13A is a cross-sectional view schematically illustrating an extended state of an electronic device having a sliding structure according to an embodiment.
FIG. 13B is a conceptual view illustrating a flexible display in the extended state of the electronic device according to an embodiment.
FIG. 14A is a cross-sectional view schematically illustrating a second reduced state of an electronic device having a sliding structure according to an embodiment.
FIG. 14B is a conceptual view illustrating a flexible display in the second reduced state of the electronic device according to an embodiment.
FIG. 14C is a conceptual view illustrating a flexible display according to a third reduced state of an electronic device according to an embodiment.
FIG. 15 is a cross-sectional view schematically illustrating a folded state (e.g., a first state) of an electronic device having an out-folding structure according to an embodiment.
FIG. 16A illustrates the front surface of the electronic device having an out-folding structure according to an embodiment.
FIG. 16B illustrates the rear surface of the electronic device having an out-folding structure according to an embodiment.
FIG. 17 illustrates an example of a notification that an electronic device having an out-folding structure according to an embodiment displays during a folded state.
FIG. 18A is a cross-sectional view schematically illustrating a folded state (e.g., a first state) of an electronic device having an out-folding structure and a sliding structure according to an embodiment.
FIG. 18B is a cross-sectional view schematically illustrating an unfolded state (e.g., a second state) of the electronic device having an out-folding structure and a sliding structure according to an embodiment.
FIG. 18C is a cross-sectional view schematically illustrating an extended state (e.g., a third state) of the electronic device having an out-folding structure and a sliding structure according to an embodiment.
FIG. 19 is a cross-sectional view schematically illustrating a second unfolded state of the electronic device having an out-folding structure and a sliding structure according to an embodiment.
FIG. 20 is a cross-sectional view schematically illustrating a second folded state of the electronic device having an out-folding structure and a sliding structure according to an embodiment.
FIG. 21 is a cross-sectional view schematically illustrating a folded state of an electronic device having an in-folding structure and a sliding structure according to an embodiment.
FIG. 22 illustrates a state in which an electronic device having a sliding structure according to an embodiment is coupled to an accessory.
FIG. 23 illustrates a state in which a portion of an accessory covers a flexible display while the electronic device having a sliding structure according to an embodiment is coupled to the accessory.
FIG. 24A illustrates a cross-section view of a flexible display of an electronic device, which has a sliding structure according to an embodiment, in a first state when an accessory is covering the flexible display.
FIG. 24B illustrates a cross-section view of the flexible display of the electronic device, which has a sliding structure according to an embodiment, in a second state when the accessory is covering the flexible display.
FIG. 25 is a flowchart illustrating operations of the electronic device having a sliding structure according to an embodiment.
FIG. 26 is a flowchart illustrating operations of the electronic device having a sliding structure according to an embodiment.

### [Mode for the Invention]

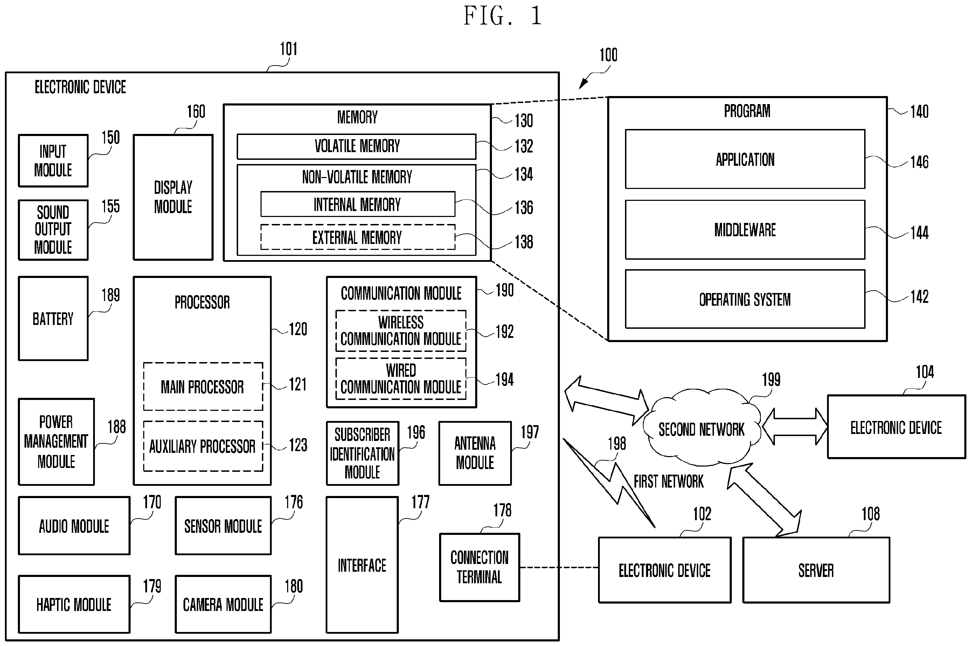

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connection terminal 178, a haptic module 179, a camera module 180, a power management module 188, a battery 189, a communication module 190, a subscriber identification module (SIM) 196, or an antenna module 197. In some embodiments, at least one of the components (e.g., the connection terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 comprises at least one processing circuitry and may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134. The memory 130 may store instructions executable by the processor 120 or the electronic device 101.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module (or display) 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 comprises at least one sensor and may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connection terminal 178 may include a connector via which the electronic device 101 may be physically connected with the external electronic device (e.g., the electronic device 102). According to an embodiment, the connection terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 comprises at least one camera and may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 comprises at least one communication circuitry and may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 comprises at least one antenna and may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.
types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Hereinafter, for ease of description, a surface where the display is visually exposed to the user may be referred to as the front surface of the electronic device 101. A surface opposite the front surface may be referred to as the rear surface of the electronic device 101. Further, a surface surrounding the space between the front and rear surfaces may be referred to as the side surface of the electronic device 101. The term "state" may refer to the structural form, posture, figure, or shape of the electronic device 101 (or a display, a slider, or a housing constituting the electronic device 101).

Various sliding structures may be applied to the electronic device 101. According to an embodiment, the electronic device 101 may include a slidable housing including a housing (or a first housing) and a slider (or a second housing), a roller that enables a slider to be inserted into the housing and enables the slider to be withdrawn from the housing, and a flexible display. The slider may be divided into a portion (hereinafter, an insertable portion) insertable into the housing and a portion that remains exposed to the outside. **In** a slide-out state (i.e., a first state, an open state, an extended state, or a roll-out state) in which the insertable portion of the slider is fully withdrawn from the housing, the entire display (or a majority of the display region) may be exposed to the outside through the front surface. As the insertable portion of the slider is inserted into the housing, the display may also be inserted into the housing. The display may also be divided into a portion (e.g., a first display region or a first section) that remains exposed to the outside and a portion (e.g., a second display region, a second section, or a bendable section) insertable into the housing. When the state switches to a slide-in state (i.e., a second state, a closed state, a reduced state, or a roll-in state) in which the entire insertable portion of the slider is inserted into the housing, the entire second display region of the display may be inserted into the housing. According to an embodiment, when the state switches from a slide-out state to a slide-in state, a portion (e.g., the second display region) of the display may not be inserted into the housing, but may be moved toward the rear surface via the side surface and placed. As in the above example, the electronic device 101 may have a sliding structure in which a portion of the display is inserted into the housing, or a sliding structure in which a portion of the display is moved from the front surface toward the rear surface and placed. Only a portion of the display exposed through the front surface may be determined to be an active region for displaying visual information. A portion of the display inserted into the housing or moved to the rear surface may be determined to be an inactive region.

The electronic device 101 may also have a sliding structure different from that in the previous example. According to an embodiment, the electronic device 101 may include a housing, a roller disposed inside the housing, and a flexible (or, rollable) display that is inserted into the housing by being wound on the roller, or withdrawn from the housing by being unwound from the roller. Even when the display is wound on the roller, a portion of the display (e.g., the first display region) may remain exposed to the outside. **In** an embodiment, the entire display region may be inserted into the housing.

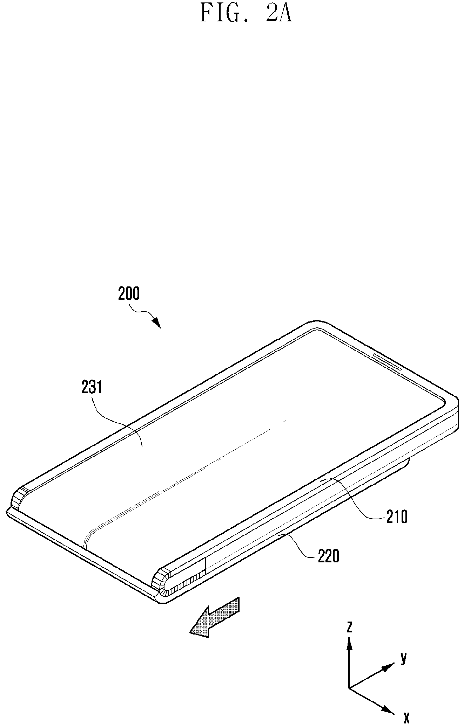

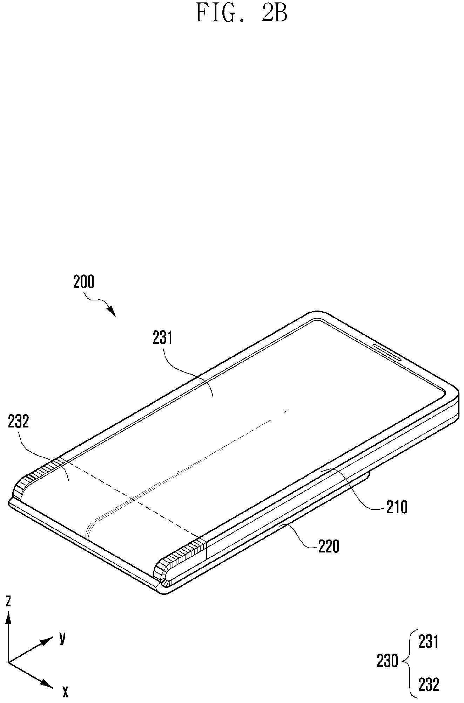

FIGS. 2A and 2B illustrate an electronic device 200 having a sliding structure according to an embodiment. Referring to FIGS. 2A and 2B, the electronic device 200 (e.g., the electronic device 101 in FIG. 1) may include a housing (or a first housing) 210, a slider (or a second housing) 220 arranged to slide with respect to the first housing 210, a flexible display 230 having a display region that is reduced or extended based on slide-in or slide-out driving of the slider 220, a motor disposed in an inner space of the electronic device 200 to generate a driving force to drive the slider 220, and a driving circuit disposed in the inner space of the electronic device 200 to drive the motor.

According to an embodiment, the slider 220 may be slidably coupled to the housing 210. The motor may be disposed in the inner space of the slider 220. The roller that is rotated by the driving force of the motor may be disposed in the inner space of the slider 220. The roller does not need to roll (rotate), and may serve to mechanically guide the display when the display is wound or unwound. The display 230 may include a first display region 231, disposed adjacent to the housing 210 and visually exposed through the front surface of the electronic device 200, and a second display region 232, insertable into the inner space. The second display region 232 may be inserted into the slider 220 and wound around the roller when the slider 220 slides toward the housing 210. The second display region 232 may be unwound from the roller and visually exposed through the front surface of the electronic device 200 when the slider 220 slides in a direction away from the housing 210 (e.g., in the -y-axis direction as illustrated in FIG. 2A).

According to an embodiment, the state of the electronic device 200 may be defined based on a rotation angle of the roller (e.g., the angle by which the roller is rotated in the direction in which the display 230 is unwound from the roller (e.g., clockwise)). For example, when the rotation angle of the roller is less than a first threshold value, the state of the electronic device 200 may be defined as a slide-in state in which only the first display region 231 of the display 230 is exposed (or the second display region 232 is disposed in the inner space). When the rotation angle of the roller is greater than or equal to the first threshold value and less than a second threshold value, the state of the electronic device 200 may be defined as a partial slide-in state (i.e., a third state, a partial slide-out state, or an intermediate state). When the rotation angle of the roller is greater than or equal to the second threshold value, the state of the electronic device 200 may be defined as a slide-out state in which the entirety of the display 230 (e.g., the first display region 231 and the second display region 232) is exposed.

According to an embodiment, the state of the electronic device 200 may be defined based on the curvature (degree of bending) of a designated part of the display 230. For example, when the curvature of the second display region 232 corresponds to a value (or falls within a range) indicative of concavity (or, convexity), the state of the electronic device 200 may be defined as a slide-in state. When the curvature of the second display region 232 corresponds a value (or falls within a range) indicative of flatness, the state of the electronic device 200 may be defined as a slide-out state.

An active region on the display 230 in which visual information (e.g., a navigation bar, a state bar, or an application execution screen) is to be displayed may be determined based on the state of the electronic device 200. For example, when the electronic device 200 is in a slide-in state, the active region may be determined to be the first display region 231 and visual information may be displayed in the first display region 231 accordingly. When the electronic device 200 is in a slide-out state, the active region may be determined to be the entire region of the display 230 (e.g., the first display region 231 and the second display region 232), and visual information may be displayed in the entire region accordingly.

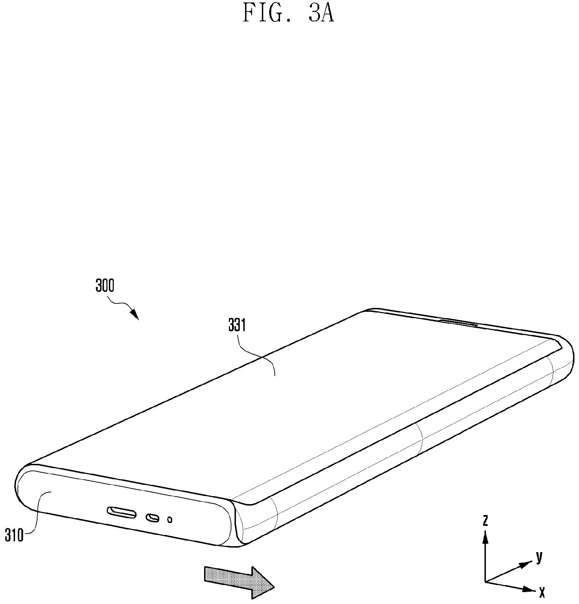

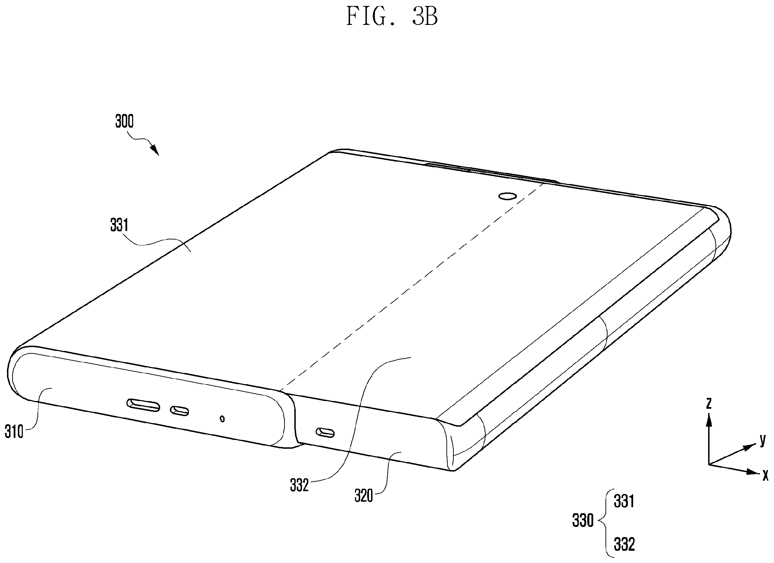

FIGS. 3A and 3B illustrate an electronic device 300 having a sliding structure according to an embodiment. In describing the electronic device 300, elements, functions, and/or structures that are redundant with those in FIG. 2 are briefly described or omitted. Referring to FIGS. 3A and 3B, the electronic device 300 (e.g., the electronic device 101 in FIG. 1) may include a housing 310, a slider 320, and a flexible display 330 disposed within a space formed by the slidable housings 310 and 320. The display 330 may include a first display region 331 disposed adjacent to the housing 310 and visually exposed through the front surface of the electronic device 300, and a second display region 332 disposed within the space formed by the slidable housings 310 and 320. The second display region 332 may be visually exposed through the front surface of the electronic device 200 as the slider 320 slides in a direction away from the housing 310 (e.g., in the x-axis direction as illustrated in FIG. 3A).

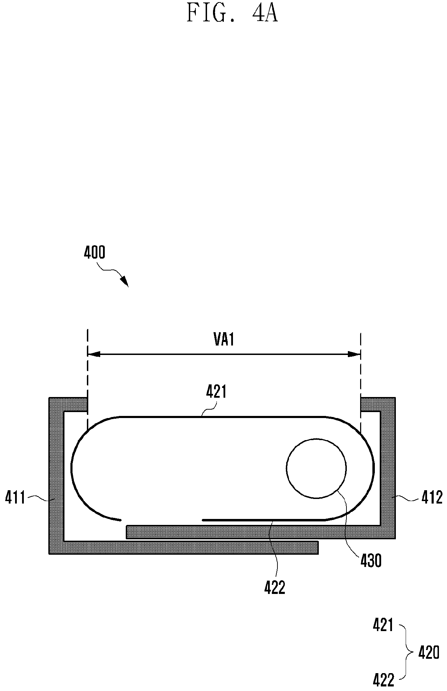

FIG. 4A is a cross-sectional view schematically illustrating a reduced state of an electronic device 400 having a sliding structure according to an embodiment.

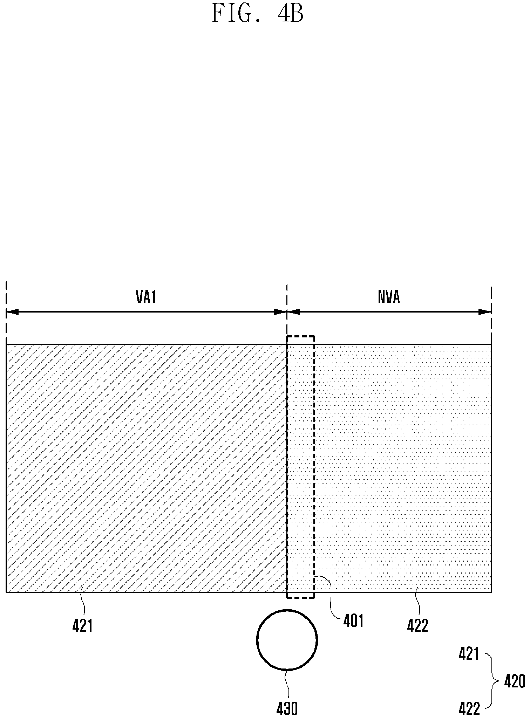

FIG. 4B is a conceptual view illustrating a flexible display 420 in the reduced state of the electronic device 400 according to an embodiment.

Referring to FIGS. 4A and 4B, the electronic device 400, according to an embodiment, may include a first housing 411 and a second housing 412, and the second housing 412 may be configured to be slide with respect to the first housing 411.

A flexible display 420 may be disposed inside the first housing 411 and the second housing 412. The flexible display 420 may be configured such that the area of a visible region (or an active region) is adjusted by movement of a roller 430 or by guidance of the roller 430. The roller 430 may be disposed inside of the second housing 412, and may be configured to guide movement of a second region 422 of the flexible display 420.

According to an embodiment, the electronic device 400 may include a motor (not shown) configured to generate a driving force for the second housing 412, and the motor may be driven by a driving circuit. According to an embodiment, a processor (e.g., the processor 120 in FIG. 1) of the electronic device 400 may control the slide-in driving or slide-out driving of the second housing 412 by controlling the driving circuit.

The flexible display 420 may be configured such that a visible region that is visible from outside the electronic device 400 is reduced or extended based on the slide-in or slide-out driving of the second housing 412. The visible region is the region formed by at least a portion of the flexible display 420, and may be referred to as the "main display region".

Referring to FIG. 4A, the reduced state of the electronic device 400 is shown in which a portion of the second housing 412 is slid into the first housing 411.

In a reduced state, a first region 421 of the flexible display 420 may be disposed to face the front surface of the electronic device 400, and the second region 422 of the flexible display 420 may be at least partially disposed inside the second housing 412, and thus is not visible from the outside. In the reduced state, the first region 421 of the flexible display 420, as the main display, may form a first visible region VA1. For example, in the reduced state, the area of the first visible region VA1 may be substantially equal to the area of the first region 421 of the flexible display 420.

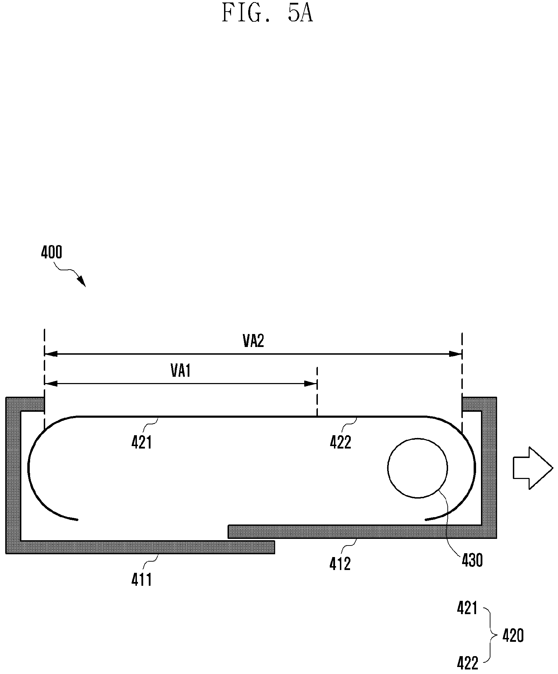

The second region 422 of the flexible display 420 may be a region adjacent to the first region 421, and may be a region that is at least partially disposed inside the second housing 412 during the reduced state. For example, the second region 422 of the flexible display 420 may be a region extending from the first region 421. The second region 422 of the flexible display 420 may be disposed to face the front surface of the electronic device 400 during an extended state, as will be described later with reference to FIG. 5A.

Referring to FIG. 4B, in the reduced state, the first region 421 of the flexible display 420 forms the first visible region VA1 to display a user screen, such as a home screen or an application execution screen. In the reduced state, the second region 422 of the flexible display 420 is a non-visible region NVA, but may display a predetermined screen to reduce deviations between the burn-in of the first region 421 and the burn-in of the second region 422.

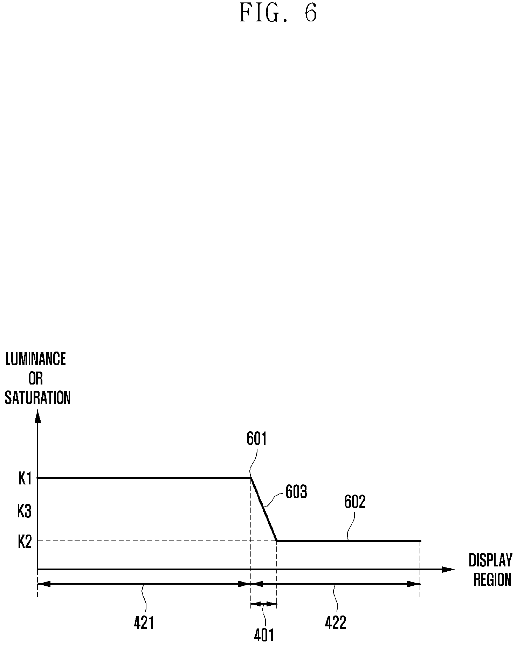

The electronic device 400 may be configured to display a designated screen through the second region 422 in a reduced state, wherein the luminance of the designated screen may be configured to decrease linearly at a boundary portion 401 of the adjacent second region 422 adjacent to the first region 421. Such operation of the electronic device 400 will be described in more detail with reference to the graph in FIG. 6.

In FIG. 4B, "NVA" may refer to a non-visible region NVA of the flexible display 420 that is not visible from outside the electronic device 400.

FIG. 5A is a cross-sectional view schematically illustrating an extended state of the electronic device 400 having a sliding structure according to an embodiment.

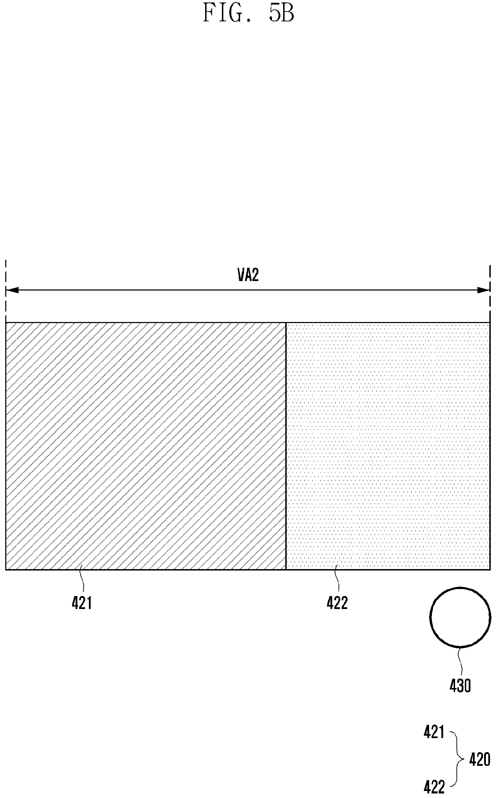

FIG. 5B is a conceptual view illustrating the flexible display 420 in the extended state of the electronic device 400 according to an embodiment.

FIGS. 5A and 5B may be examples of illustrating the extended state of the electronic device 400 according to an embodiment described with reference to FIGS. 4A and 4B.

According to an embodiment, the electronic device 400 may receive an extension trigger event during a reduced state. The extension trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the extension trigger event, the electronic device 400 may switch from the reduced state to an extended state in which a portion of the second housing 412 slides out from the interior of the first housing 411.

The second region 422 of the flexible display 420 may, in conjunction with the slide-out driving of the second housing 412, be withdrawn from inside the second housing 412 to form a second visible region VA2, which is visible from outside the electronic device 400, along with the first region 421.

Referring to FIG. 5A, an extended state of the electronic device 400 is shown in which a portion of the second housing 412 slides out from the interior of the first housing 411.

In the extended state, the first region 421 and the second region 422 of the flexible display 420 are disposed to face the front surface of the electronic device 400 so that the first region 421 and the second region 422 (e.g., at least a portion of the second region 422) of the flexible display 420 are visible from the outside. In the extended state, the first region 421 and the second region 422 (e.g., at least a portion of the second region 422) of the flexible display 420, as the main display, may form the second visible region VA2. For example, the area of the second visible region VA2 corresponding to the extended state may be larger than the area of the first visible region VA1 corresponding to the reduced state. According to an embodiment, the area of the second visible region VA2 corresponding to the extended state may be substantially equal to the sum of the area of the first region 421 and the area of the second region 422 (e.g., at least a portion of the second region 422).

The second region 422 of the flexible display 420 may be a region extending from the first region 421 (or a region adjacent to the first region 421), and may be configured to be withdrawn from inside the second housing 412 in conjunction with the slide-out driving of the second housing 412.

Referring to FIG. 5B, in the extended state, the first region 421 and the second region 422 (e.g., at least a portion of the second region 422) of the flexible display 420 may form the second visible region VA2 to display a user screen, such as a home screen, or an application execution screen.

FIG. 6 is a graph depicting display data used to drive the flexible display 420 when the electronic device 400 according to an embodiment is in a reduced state.

Referring to FIG. 6, a method by which the electronic device 400, according to an embodiment described with reference to FIGS. 4A to 5B, reduces image quality deviation in the flexible display 420 is illustrated.

The electronic device 400 according to an embodiment is configured to have a sliding structure that adjusts the visible region of the flexible display 420, and accordingly, the burn-in state of the first region 421 and the burn-in state of the second region 422 may have a deviation. The electronic device 400 according to an embodiment controls the second region 422 to display a designated screen in a reduced state to compensate for the deviation.

The electronic device 400 according to an embodiment may display the designated screen through the second region 422 in the reduced state, wherein the luminance of the designated screen is configured to linearly decrease at the boundary portion 401 of the second region 422 adjacent to the first region 421.

By configuring the luminance of the designated screen to decrease linearly, the electronic device 400 may reduce image quality deviation that may occur in the form of a line at a boundary between the first region 421 and the second region 422. For example, when the burn-in state of the first region 421 is different from the burn-in state of the second region 422, poor image quality in the form of lines may occur along the boundary between the first region 421 and the second region 422.

According to an embodiment, the electronic device 400 may configure the luminance of the designated screen displayed through the boundary portion 401 of the second region 422 to be higher in proximity to the first region 421.

According to an embodiment, the electronic device 400 may configure the luminance of the designated screen displayed through the boundary portion 401 of the second region 422 to be lower with increasing distance from the first region 421.

At the boundary portion 401 of the second region 422, the first portion region 601 that is relatively closer to the first region 421 may be configured to display a first luminance K1 that is equal to or similar to the average luminance of the first region 421, and the first luminance K1 may be the maximum luminance of the designated screen.

At a boundary portion 401 of the second region 422, a second portion region 602 that is relatively farther from the first region 421 may be configured to display a second luminance K2 that is a lowest luminance of the designated screen displayed through the second region 422.

At the boundary portion 401 of the second region 422, a third portion region 603 between the first portion region and the second portion region may be configured to display a third luminance K3 that is darker than the first luminance K1 and brighter than the second luminance K2.

In the example in FIG. 6, the luminance corresponding to the boundary portion 401 of the second region 422 is described as being linearly adjusted, but the electronic device 400 according to an embodiment may not be limited thereto. For example, the electronic device 400 according to an embodiment may linearly adjust the saturation as well as the luminance corresponding to the boundary portion 401 of the second region 422.

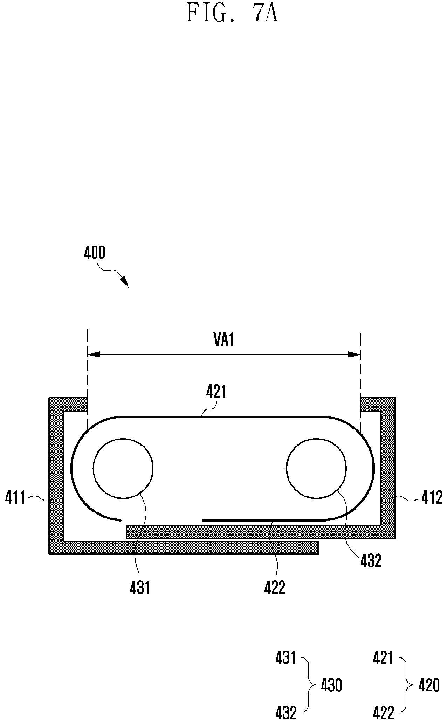

FIG. 7A is a cross-sectional view schematically illustrating a first reduced state of an electronic device 400 having a sliding structure according to an embodiment.

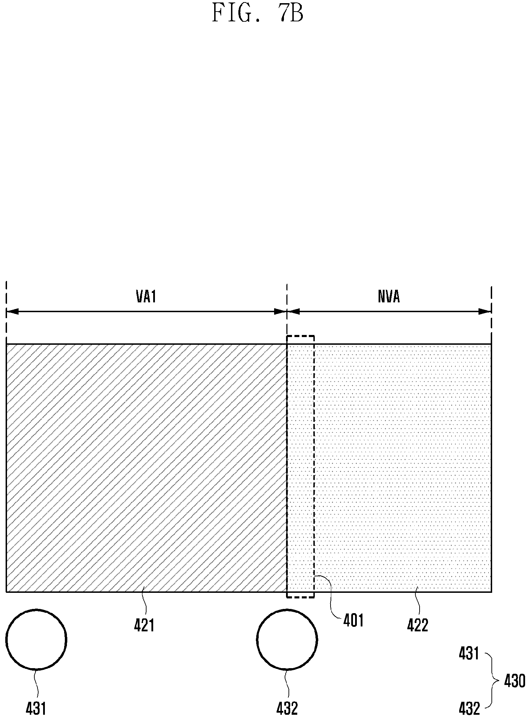

FIG. 7B is a conceptual view illustrating the flexible display 420 in the first reduced state of the electronic device 400 according to an embodiment.

Referring to FIGS. 7A and 7B, the electronic device 400 according to an embodiment may include a first housing 411 and a second housing 412, and the second housing 412 may be configured to be slide with respect to the first housing 411.

A flexible display 420 may be disposed inside the first housing 411 and the second housing 412. The flexible display 420 may be configured such that the area of a visible region is adjusted by movement of rollers 430 or by guidance of the rollers 430. The rollers 430 may include a first roller 431 that guides movement of a first region 421 of the flexible display 420, and a second roller 432 that guides movement of a second region 422 of the flexible display 420. The first roller 431 may be disposed inside the first housing 411 so as to allow a portion of the first region 421 of the flexible display 420 to be inserted into the first housing 411 or withdrawn from inside the first housing 411. The second roller 432 may be disposed inside the second housing 412 so as to allow a portion of the second region 422 of the flexible display 420 to be inserted into the second housing 412 or withdrawn from inside the second housing 412.

According to an embodiment, the electronic device 400 may include a motor (not shown) that generates a driving force for the second housing 412, and the motor may be driven by a driving circuit. According to an embodiment, a processor 120 of the electronic device 400 may control the slide-in driving or slide-out driving of the second housing 412 by controlling the driving circuit.

The flexible display 420 may be configured such that a visible region, which is visible from outside the electronic device 400, is reduced or extended based on the slide-in or slide-out driving of the second housing 412. The visible region is a region formed by at least a portion of the flexible display 420, and may be referred to as the "main display region".

Referring to FIG. 7A, the first reduced state of the electronic device 400 is shown in which a portion of the second housing 412 slides into the first housing 411.

In the first reduced state, the first region 421 of the flexible display 420 may be disposed to face the front surface of the electronic device 400, and the second region 422 of the flexible display 420 may be at least partially disposed inside the second housing 412, and thus may not be visible from the outside. In the first reduced state, the first region 421 of the flexible display 420, as a main display, may form a first visible region VA1. For example, in the first reduced state, the area of the first visible region VA1 may be substantially equal to the area of the first region 421 of the flexible display 420.

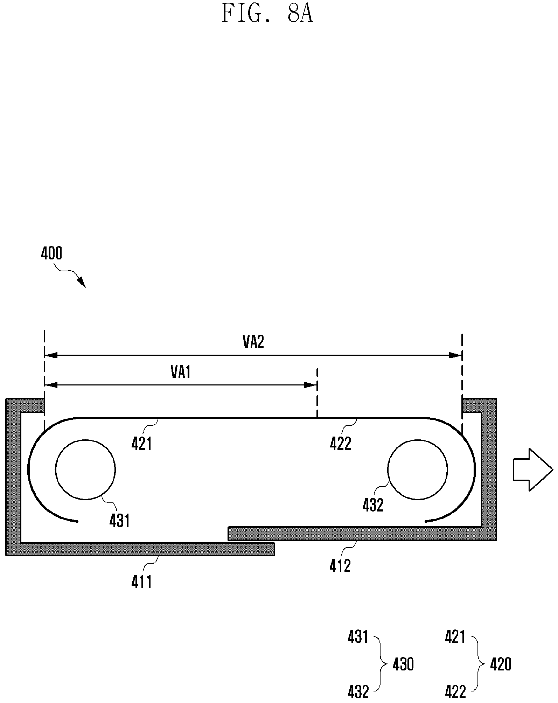

The second region 422 of the flexible display 420 may be a region extending from the first region 421, and may be a region disposed inside the second housing 412 during the first reduced state. The second region 422 of the flexible display 420 may be disposed to face the front surface of the electronic device 400 during an extended state, as will be described later with reference to FIG. 8A.

Referring to FIG. 7B, in the first reduced state, the first region 421 of the flexible display 420 forms the first visible region VA1 to display a user screen, such as a home screen, or an application execution screen. In the first reduced state, the second region 422 of the flexible display 420 is a non-visible region NVA, but may display a predetermined screen to reduce the deviation of the burn-in of the first region 421 and the burn-in of the second region 422.

The electronic device 400 may display a designated screen through the second region 422 in the first reduced state, wherein the luminance of the specified screen is configured to linearly decrease at a boundary portion 401 of the second region 422 adjacent to the first region 421. A description of the operation of the electronic device 400 will be replaced with the description made with reference to the graph in FIG. 6.

In FIG. 7B, "NVA" denotes a non-visible region NVA of the flexible display 420 that is not visible from outside the electronic device 400.

FIG. 8A is a cross-sectional view schematically illustrating an extended state of an electronic device 400 having a sliding structure according to an embodiment.

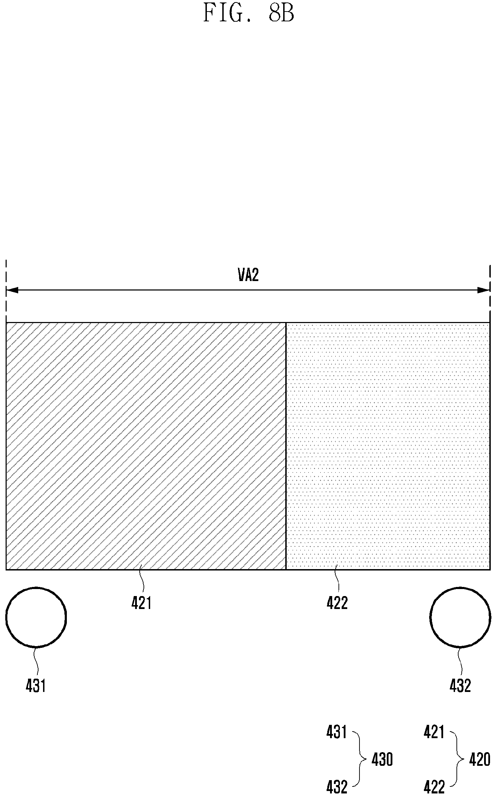

FIG. 8B is a conceptual diagram illustrating a flexible display 420 in the extended state of the electronic device 400 according to an embodiment.

FIGS. 8A and 8B may be examples of illustrating an extended state of the electronic device 400 according to an embodiment described with reference to FIGS. 7A and 7B.

According to an embodiment, the electronic device 400 may receive an extension trigger event during the first reduced state. The extension trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the extension trigger event, the electronic device 400 may switch from the first reduced state to an extended state in which a portion of the second housing 412 slides out from the interior of the first housing 411.

The second region 422 of the flexible display 420 may, in conjunction with the slide-out driving of the second housing 412, be withdrawn from inside the second housing 412 to form a second visible region VA2, which is visible from outside the electronic device 400, along with the first region 421.

Referring to FIG. 8A, an extended state of the electronic device 400 is shown in which a portion of the second housing 412 slides out from the interior of the first housing 411.

In the extended state, the first region 421 and the second region 422 (e.g., at least a portion of the second region 422) of the flexible display 420 are disposed to face the front surface of the electronic device 400 so that the first region 421 and the second region 422 of the flexible display 420 are visible from the outside. In the extended state, the first region 421 and the second region 422 (e.g., at least a portion of the second region 422) of the flexible display 420, as the main display, may form the second visible region VA2. For example, the area of the second visible region VA2 corresponding to the extended state may be larger than the area of the first visible region VA1 corresponding to the reduced state. According to an embodiment, the area of the second visible region VA2 corresponding to the extended state may be substantially equal to the sum of the area of the first region 421 and the area of the second region 422 (e.g., at least a portion of the second region 422).

The second region 422 of the flexible display 420 may be a region extending from the first region 421, and may be configured to be withdrawn from inside the second housing 412 in conjunction with a slide-out driving of the second housing 412.

Referring to FIG. 8B, in the extended state, the first region 421 and the second region 422 (e.g., at least a portion of the second region 422) of the flexible display 420 may form the second visible region VA2 to display a user screen, such as a home screen, or an application execution screen.

In FIGS. 8A and 8B, reference numeral 430, which has not been described, is "rollers" that guide movement of the flexible display 420, reference numeral 431 is a "first roller" that guides movement of the first region 421, and reference numeral 432 is a "second roller" that guides movement of the second region 422.

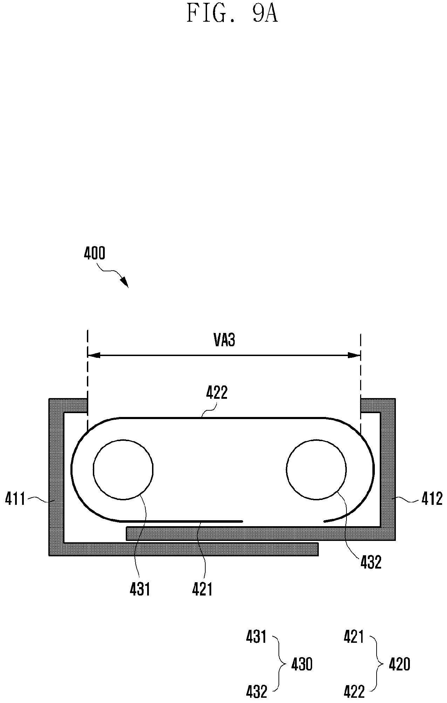

FIG. 9A is a cross-sectional view schematically illustrating a second reduced state of an electronic device 400 having a sliding structure according to an embodiment.

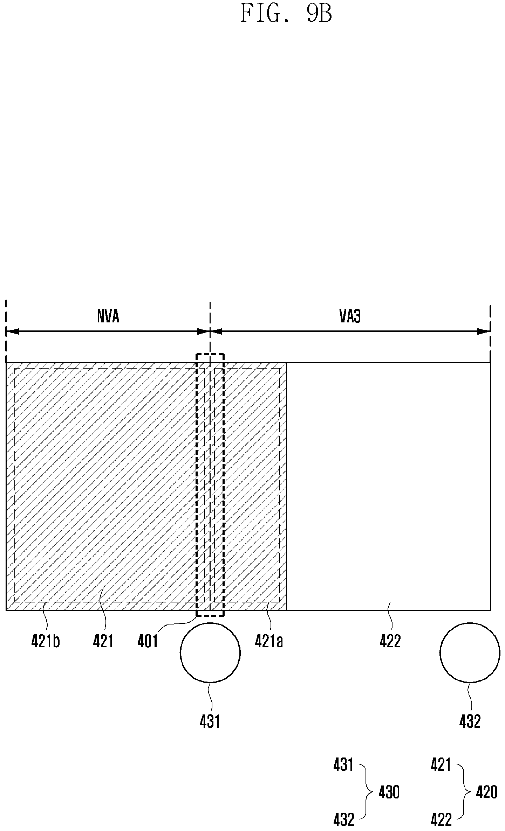

FIG. 9B is a conceptual view illustrating a flexible display 420 in the second reduced state of the electronic device 400 according to an embodiment.

Referring to FIG. 9A, the second reduced state of the electronic device 400 is shown in which a portion of a second housing 412 slides into a first housing 411.

According to an embodiment, the electronic device 400 may receive a reduction trigger event during an extended state. The reduction trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the reduction trigger event, the electronic device 400 may switch from the extended state (e.g., FIG. 8A) to the second reduced state in which a portion of the second housing 412 slides into the first housing 411. In terms of the external appearance of the electronic device 400, the second reduced state illustrated in FIGS. 9A and 9B may be substantially the same as the first reduced state described with reference to FIGS. 7A and 7B. The second reduced state illustrated in FIGS. 9A and 9B may differ from the first reduced state described with reference to FIGS. 7A and 7B in terms of the region of the flexible display 420 that forms a visible region. For example, the first reduced state is a state in which a first region 421 of the flexible display 420 forms a visible region, wherein the first region 421 of the flexible display 420 may function as a main display. The second reduced state is a state in which a second region 422 of the flexible display 420 forms a visible region, or the second region 422 and a portion of the first region 421 of the flexible display 420 form a visible region, wherein the second region 422 of the flexible display 420 may function as a main display, or the second region 422 and a portion 421a of the first region 421 of the flexible display 420 may function as the main display. For example, in the second reduced state, the portion 421a of the first region 421 adjacent to the second region 422 may be configured to function as the main display, while the remaining portion 421b of the first region 421 may be inserted into the first housing 411 and configured as a non-visible region NVA (e.g., an inactive region).

According to an embodiment, the second reduced state may be a state in which the second region 422 of the flexible display 420 forms a visible region alone.

According to an embodiment, the second reduced state may be a state in which a portion of the second region 422 of the flexible display 420 and a portion of the first region 421 form a visible region.

In the disclosure, the fact that a portion of the flexible display 420 functions as the main display may imply that the portion of the flexible display 420 is configured to display a user screen, such as a home screen, or an application execution screen.

Referring to FIGS. 9A and 9B, in the second reduced state, the second region 422 and a portion of the first region 421 of the flexible display 420 may form a third visible region VA3 to display a user screen, such as a home screen, or an application execution screen.

Referring to FIG. 9B, in the second reduced state, the electronic device 400 may display a designated screen through the remaining portion 421b of the first region 421 that is inserted into the first housing 411, wherein the luminance of the designated screen is configured to linearly decrease at a boundary portion 401 between the remaining portion 421b of the first region 421 displaying the designated screen and the portion 421a of the first region 421 forming the visible region. A description of the operation of the electronic device 400 will be replaced with the description made with reference to the graph in FIG. 6.

The area of the third visible region VA3, described with reference to FIGS. 9A and 9B, may be substantially equal to the area of the first visible region VA1, described with reference to FIGS. 7A and 7B. Thus, in terms of the external appearance of the electronic device 400, the first reduced state may be substantially the same as the second reduced state, differing only in a region of the flexible display 420 forming a visible region.

The electronic device 400 according to an embodiment may reduce image quality deviation in the flexible display 420 by adjusting the region of the flexible display 420 that forms the visible region in the reduced state.

In FIG. 9B, "NVA" denotes a non-visible region NVA of the flexible display 420 that is not visible from outside the electronic device 400.

In FIGS. 9A and 9B, reference numeral 430, which has not been described, is "rollers" that guide movement of the flexible display 420, reference numeral 431 is a "first roller" that guides movement of the first region 421, and reference numeral 432 is a "second roller" that guides movement of the second region 422.

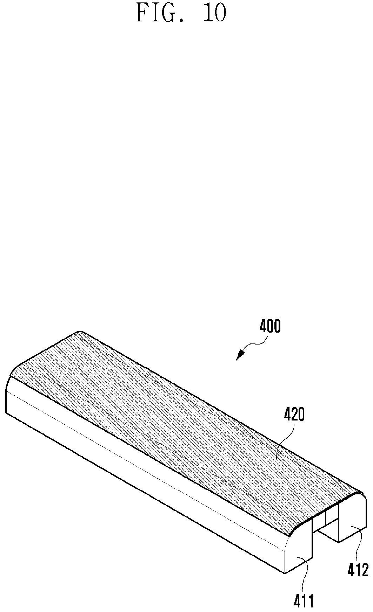

FIG. 10 is a perspective view schematically illustrating a reduced state of an electronic device 400 having a sliding structure according to an embodiment.

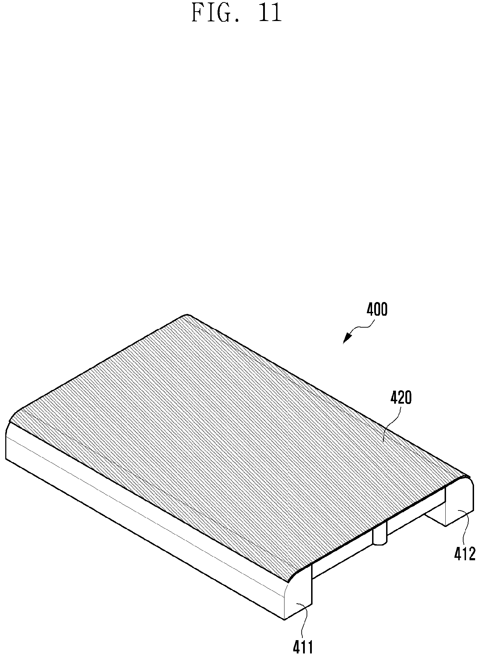

FIG. 11 is a perspective view schematically illustrating an extended state of the electronic device 400 having a sliding structure according to an embodiment.

Referring to FIGS. 10 and 11, the electronic device 400 according to an embodiment may include a flexible display 420 that is extendable in both left and right directions or in both upward and downward directions. One end of the flexible display 420 may be configured to be inserted into a first housing 411 or withdrawn from inside the first housing 411. The other end of the flexible display 420 may be configured to be inserted into a second housing 412 or withdrawn from inside the second housing 412.

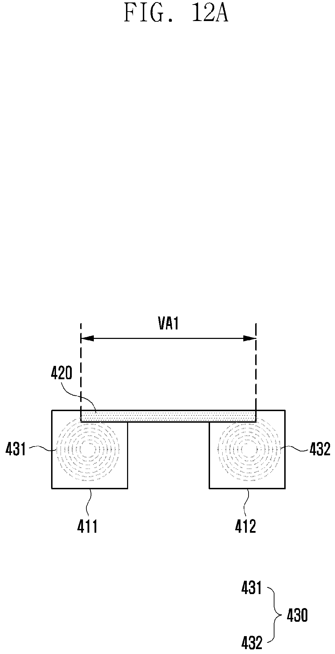

Inside the first housing 411, a first roller member (e.g., a first roller member 431 in FIG. 12A) may be disposed, and the first roller member may be configured to wind one end of the flexible display 420 in the form of a jelly roll when the one end of the flexible display 420 is inserted into the first housing 411. In response to an event that widens the gap between the first housing 411 and the second housing 412, the first roller member may withdraw at least a portion of the flexible display 420, which is wound around the first roller member, from the first housing 411 to the outside.

Inside the second housing 412, a second roller member (e.g., a second roller member 432 in FIG. 12A) is disposed, and the second roller member may wind one end of the flexible display 420 in the form of a jelly roll when the one end of the flexible display 420 is inserted into the second housing 412. In response to an event that widens the gap between the first housing 411 and the second housing 412, the second roller member may withdraw at least a portion of the flexible display 420, which is wound around the second roller member, from the second housing 412 to the outside.

Referring to FIG. 10, a reduced state is shown in which the distance between the first housing 411 and the second housing 412 is a first distance that is a predetermined minimum distance. In the reduced state, the electronic device 400 may be configured such that a portion of the flexible display 420 functions as a main display.

Referring to FIG. 11, an extended state is shown in which the distance between the first housing 411 and the second housing 412 is a second distance that is a predetermined maximum distance. In the extended state, the electronic device 400 may be configured such that all (or most) of the flexible display 420 functions as the main display.

FIG. 12A is a cross-sectional view schematically illustrating a first reduced state of an electronic device 400 having a sliding structure according to an embodiment.

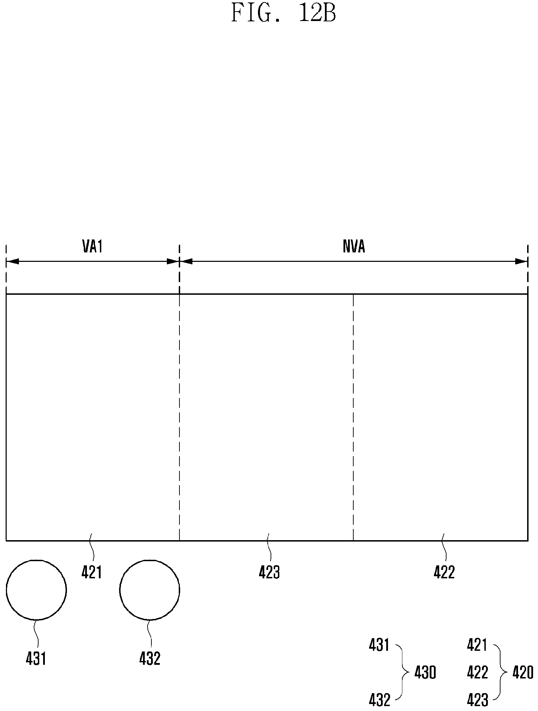

FIG. 12B is a conceptual view illustrating a flexible display 420 in the first reduced state of the electronic device 400 according to an embodiment.

FIGS. 12A and 12B may be examples of illustrating the first reduced state of the electronic device 400 according to an embodiment described with reference to FIGS. 10 and 11.

Referring to Figures 12A and 12B, the electronic device 400, according to an embodiment, may include a first housing 411 and a second housing 412, and the first housing 411 and the second housing 412 may be configured to have shapes that are symmetrical to each other.

Each of the first housing 411 and the second housing 412 may be a rod-shaped housing for accommodating the flexible display 420, and may include an opening (not shown) through which a portion of the flexible display 420 is inserted or withdrawn.

According to an embodiment, the display region of the flexible display 420 may be divided into a plurality of regions. In the first reduced state, some of the plurality of regions of the flexible display 420 may functions as a main display, and the remaining regions, excluding some regions, may be disposed inside the first housing 411 or inside the second housing 412.

According to an embodiment, the display region of the flexible display 420 may include a first region 421, a second region 422, and a third region 423. However, this is merely one example, and the display region of the flexible display 420 may be divided into more regions. The first region 421 may be disposed at one end of display region of the flexible display 420. The second region 422 may be disposed at the other end of the display region of the flexible display 420. The third region 423 may be a region between the first region 421 and the second region 422. The area of the first region 421 may be substantially equal to the area of the second region 422. The area of the first region 421 may be substantially equal to the area of the third region 423. The areas of the first region 421 and the third region 423 may each be substantially the same.

Referring to FIG. 12B, in the first reduced state, the first region 421 of the flexible display 420 may form a first visible region VA1. The second region 422 and third region 423, other than the first region 421 of the flexible display 420, may be positioned inside the second housing 412. The first region 421 of the flexible display 420, as the main display, may form the first visible region VA1. The second region 422 and third region 423 are non-visible regions (NVA), but may display a designated screen while being positioned inside the second housing 412 to reduce burn-in variation.

In FIG. 12B, "NVA" denotes a non-visible region NVA of the flexible display 420 that is not visible from outside the electronic device 400.

In FIGS. 12A and 12B, reference numeral 430, which has not been described, is "roller members" that guide movement of the flexible display 420, reference numeral 431 is a "first roller member", and reference numeral 432 is a "second roller member.

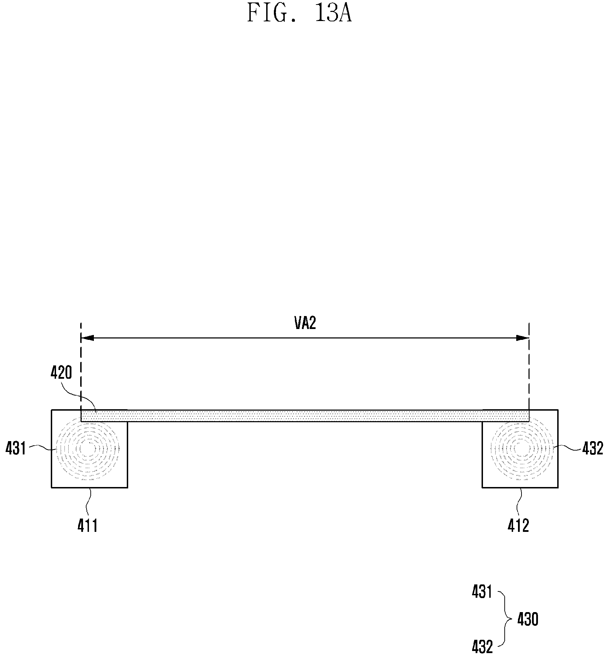

FIG. 13A is a cross-sectional view schematically illustrating an extended state of an electronic device 400 having a sliding structure according to an embodiment.

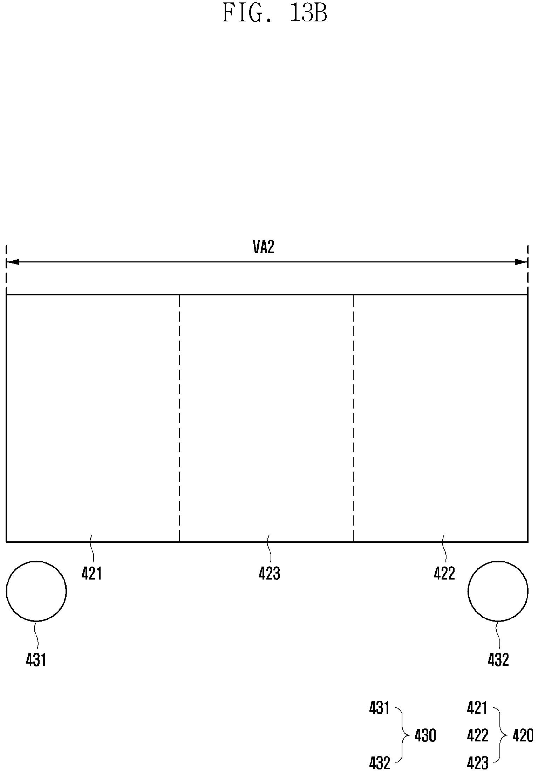

FIG. 13B is a conceptual view illustrating a flexible display 420 in the extended state of the electronic device 400 according to an embodiment.

FIGS. 13A and 13B may be examples of illustrating the extended state of the electronic device 400 according to an embodiment described with reference to FIGS. 10 and 11.

According to an embodiment, the electronic device 400 may receive an extension trigger event during the first reduced state. The extension trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the extension trigger event, the electronic device 400 may switch from the first reduced state to an extended state (e.g., FIG. 11) in which the distance between the first housing 411 and the second housing 412 is a second distance that is a predetermined maximum distance. When the electronic device 400 switches from the first reduced state to the extended state, only some of the roller members 430 may rotate. For example, when the electronic device 400 switches from the first reduced state to the extended state, the first roller member 431 may be fixed and only the second roller member 432 may rotate.

A portion (e.g., the second region 422 and the third region 423) of the flexible display 420, positioned inside the second housing 412, may be withdrawn from the second housing 412 based on the rotation of the second roller member 432, thereby forming a portion of a second visible region VA2.

In the extended state, the first region 421, the second region 422, and the third region 423 of the flexible display 420 may be arranged to face the front surface of the electronic device 400, and thus may be visible from the outside. In the extended state, the first region 421, the second region 422, and the third region 423 of the flexible display 420 may form the second visible region VA2 as the main display. For example, the area of the second visible region VA2 corresponding to the extended state may be larger than the area of the first visible region VA1 corresponding to the first reduced state. According to an embodiment, the area of the second visible region VA2 corresponding to the extended state may be substantially equal to the sum of the area of the first region 421, the area of the second region 422, and the area of the third region 423.

Referring to FIG. 13B, in the extended state, the first region 421, the second region 422, and the third region 423 of the flexible display 420 may form the second visible region VA2 to display a user screen, such as a home screen, or an application execution screen.

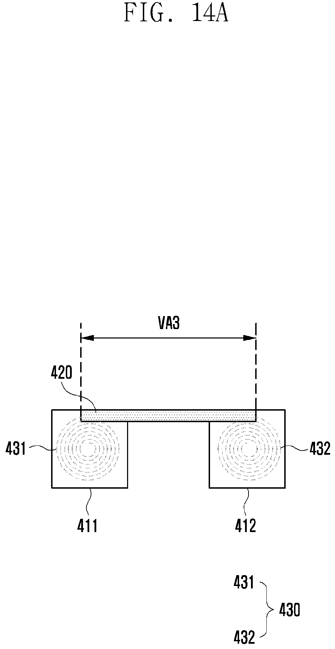

FIG. 14A is a cross-sectional view schematically illustrating a second reduced state of an electronic device 400 having a sliding structure according to an embodiment.

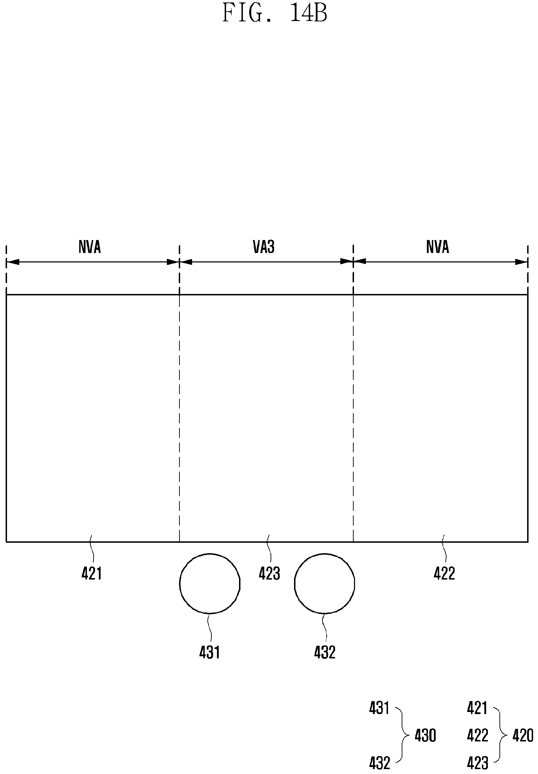

FIG. 14B is a conceptual view illustrating a flexible display 420 in the second reduced state of the electronic device 400 according to an embodiment.

FIGS. 14A and 14B may be examples of illustrating the second reduced state of the electronic device 400 according to an embodiment described with reference to FIGS. 10 and 11.

According to an embodiment, the electronic device 400 may receive a reduction trigger event during an extended state (e.g., FIG. 11). The reduction trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the reduction trigger event, the electronic device 400 may switch from the extended state to the second reduced state. In terms of the external appearance of the electronic device 400, the second reduced state illustrated in FIGS. 14A and 14B may be substantially the same as the first reduced state described with reference to FIGS. 12A and 12B. The second reduced state illustrated in FIGS. 14A and 14B may differ from the first reduced state described with reference to FIGS. 12A and 12B in terms of a region of the flexible display 420 that forms a visible region. For example, the first reduced state is a state in which the first region 421 of the flexible display 420 forms a visible region, wherein the first region 421 of the flexible display 420 may function as a main display. The second reduced state is a state in which the third region 423 of the flexible display 420 forms a visible region, wherein the third region 423 of the flexible display 420 may function as a main display

In the disclosure, the fact that a portion of the flexible display 420 functions as the main display may imply that the portion of the flexible display 420 is configured to display a user screen, such as a home screen, or an application execution screen.

Referring to FIG. 14B, in the second reduced state, the third region 423 of the flexible display 420 may form a third visible region VA3 to display a user screen, such as a home screen, or an application execution screen.

Referring to FIG. 14B, in the second reduced state of the electronic device 400, the first region 421 of the flexible display 420 inserted into the first housing 411 and the second region 422 of the flexible display 420 inserted into the second housing 412 may display a designated screen to reduce image quality degradation due to burn-in deviation.

The area of the third visible region VA3 may be substantially equal to the area of the first visible region VA1 described with reference to FIGS. 12A and 12B.

The electronic device 400 according to an embodiment may reduce image quality deviation in the flexible display 420 by adjusting the region of the flexible display 420 that forms the visible region in a reduced state (e.g., the second reduced state).

In FIG. 14B, "NVA" denotes a non-visible region NVA of the flexible display 420 that is not visible from outside the electronic device 400.

In FIGS. 14A and 14B, reference numeral 430, which has not been described, is "roller members" that guide movement of the flexible display 420, reference numeral 431 is a "first roller member" , and reference numeral 432 is a "second roller member".

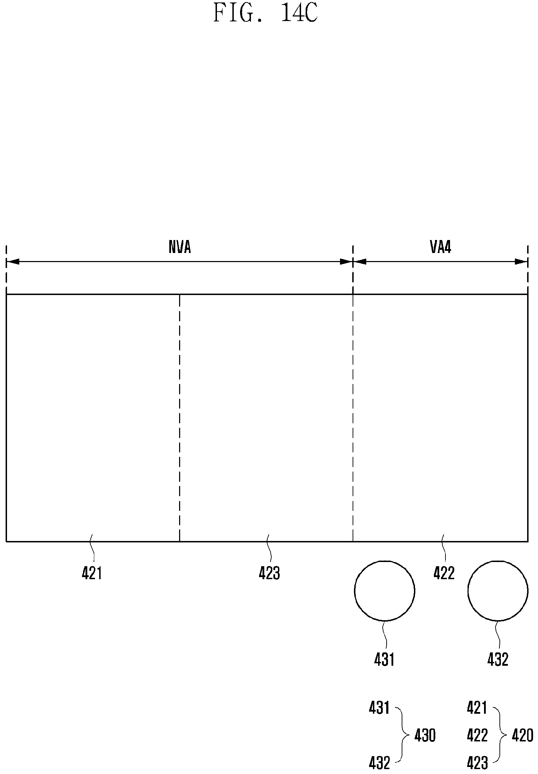

FIG. 14C is a conceptual view illustrating a flexible display 420 according to a third reduced state of an electronic device 400 according to an embodiment.

FIG. 14C may be an example of illustrating the third reduced state of the electronic device 400 according to an embodiment described with reference to FIGS. 10 and 11.

According to an embodiment, the electronic device 400 may receive a reduction trigger event during an extended state (e.g., FIG. 11). The reduction trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In response to the reduction trigger event, the electronic device 400 may switch from the extended state to the third reduced state. In terms of the external appearance of the electronic device 400, the third reduced state illustrated in FIGS. 14C may be substantially the same as the first reduced state described with reference to FIGS. 12A and 12B. The third reduced state illustrated may differ from the first reduced state described with reference to FIGS. 12A and 12B in terms of a region of the flexible display 420 that forms a visible region. For example, the third reduced state is a state in which the second region 422 of the flexible display 420 forms a visible region, wherein the second region 422 of the flexible display 420 may function as a main display.

According to an embodiment, the electronic device 400 may monitor the degree of burn-in of each of the first region 421, the second region 422, and the third region 423 of the flexible display 420 and, based on the monitoring results, switch from an extended state to the second reduced state (e.g., FIG. 14B), or from an extended state to the third reduced state (e.g., FIG. 14C).

Referring to FIG. 14C, in the third reduced state, the second region 422 of the flexible display 420 may form a fourth visible region VA4 to display a user screen, such as a home screen, or an application execution screen.

Referring to FIG. 14C, in the third reduced state of the electronic device 400, the first region 421 and the third region 423 of the flexible display 420 inserted into the first housing 411 may display a designated screen to reduce image quality degradation due to burn-in deviation.

The area of the fourth visible region VA4 may be substantially equal to the area of the first visible region VA1 described with reference to FIGS. 12A and 12B.

In FIG. 14C, "NVA" denotes a non-visible region NVA of the flexible display 420 that is not visible from outside the electronic device 400.

In FIG. 14C, reference numeral 430, which has not been described, is "roller members" that guide movement of the flexible display 420, reference numeral 431 is a "first roller member" , and reference numeral 432 is a "second roller member".

The electronic device 400, according to an embodiment, may reduce image quality deviation in the flexible display 420 by adjusting a region of the flexible display 420 that forms a visible region in a reduced state.

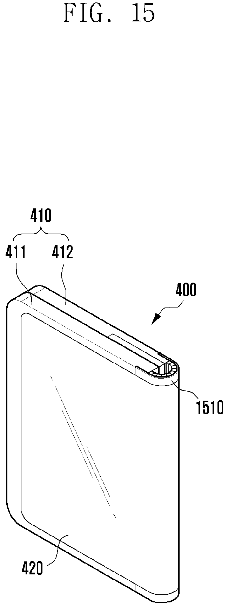

FIG. 15 is a cross-sectional view schematically illustrating a folded state (e.g., a first state) of an electronic device 400 having an out-folding structure according to an embodiment.

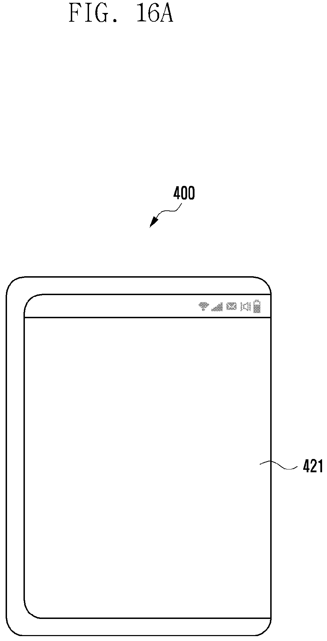

FIG. 16A illustrates the front surface of the electronic device 400 having an out-folding structure according to an embodiment.

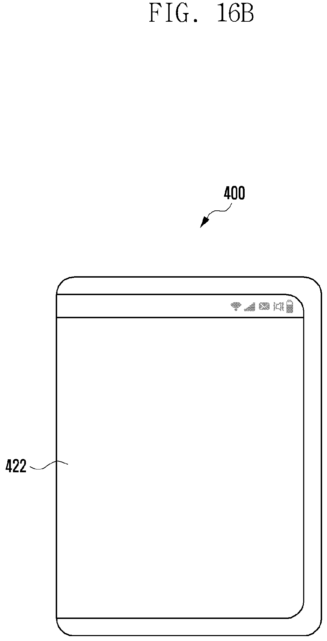

FIG. 16B illustrates the rear surface of the electronic device 400 having an out-folding structure according to an embodiment.

Referring to FIG. 15, according to an embodiment, the electronic device 400 may be an electronic device 400 having an out-folding structure. The electronic device 400 includes a housing 410 (e.g., a first housing 411 and a second housing 412) that can be folded and unfolded. A flexible display 420 may be a single display extending from one surface of the first housing 411 to one surface of the second housing 412 via a hinge region 1510. The flexible display 420 may be disposed on the outer surface of each of the first housing 411 and the second housing 412, rather than on the inner surfaces of the first housing 411 and the second housing 412 facing each other while the electronic device 400 is folded.

Referring to FIG. 16A, the electronic device 400 having an out-folding structure according to an embodiment may configure a first portion 421 of the flexible display 420, which corresponds to one surface of the first housing 411 during the folded state, as a main display, and may configure a second portion 422, other than the first portion 421, to be in an inactive state (e.g., a display-off state). For example, the electronic device 400 may display a user screen through the first portion 421 of the flexible display 420 in the folded state, wherein the second portion 422 facing a direction opposite the direction faced by the first portion 421 may be configured to be in an inactive state (e.g., a display-off state). For example, the electronic device 400 having an out-folding structure according to an embodiment may detect the direction of the first portion 421 or the direction of the second portion 422 by using a sensor (e.g., an acceleration sensor) for detecting the posture of the electronic device 400 during the folded state. When the first portion 421 is facing an upward direction (e.g., a direction opposite the direction of gravity), the electronic device 400 may configure the first portion 421 as a main display, and may configure the second portion 422, other than the first portion 421, to be in an inactive state (e.g., a display-off state).

Referring to FIG. 16B, the electronic device 400 having an out-folding structure according to an embodiment may configure the second portion 422 of the flexible display 420, which corresponds to one surface of the second housing 412 during the folded state, as a main display, and may configure the first portion 421, other than the second portion 422, to be in an inactive state (e.g., a display-off state). For example, the electronic device 400 may display a user screen through the second portion 422 of the flexible display 420 in the folded state, wherein the first portion 421 facing a direction opposite the direction faced by the second portion 422 may be configured to be in an inactive state (e.g., a display-off state). For example, the electronic device 400 having an out-folding structure according to an embodiment may detect the direction of the first portion 421 or the direction of the second portion 422 by using a sensor (e.g., an acceleration sensor) for detecting the posture of the electronic device 400 during the folded state. When the second portion 422 is facing an upward direction (e.g., a direction opposite the direction of gravity), the electronic device 400 may configure the second portion 422 as a main display, and may configure the first portion 421, other than the second portion 422, to be in an inactive state (e.g., a display-off state).

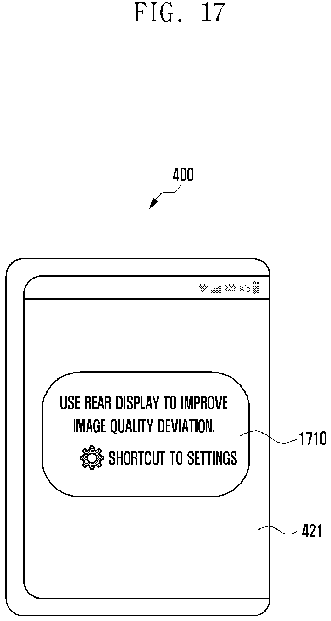

FIG. 17 illustrates an example of a notification that an electronic device 400 having an out-folding structure according to an embodiment displays during a folded state.

FIG. 17 may be an example of illustrating the front surface of the electronic device 400 according to an embodiment described with reference to FIGS. 15 to 16B.

The electronic device 400 may count usage time while the first portion 421 of the flexible display 420 is configured as a main display in a folded state. The electronic device 400 may output a notification 1710, as illustrated in FIG. 17, when the usage time exceeds a predetermined threshold value. The notification 1710 may include a message instructing a user to use the second portion 422 of the flexible display 420 as a main display in order to reduce image quality deviation. The message may be in the form of text, as shown, but is not limited thereto and may also be in the form of speech or vibration.

When the user uses the first portion 421 of the flexible display 420 as a main display for a long time in the folded state, the electronic device 400 according to an embodiment may by provide the notification 1710, thereby prompting the user to use the second portion 422 of the flexible display 420 as the main display.

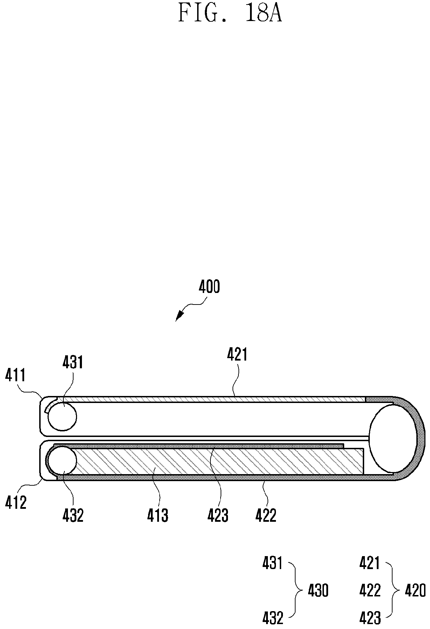

FIG. 18A is a cross-sectional view schematically illustrating a folded state (e.g., a first state) of an electronic device 400 having an out-folding structure and a sliding structure according to an embodiment.

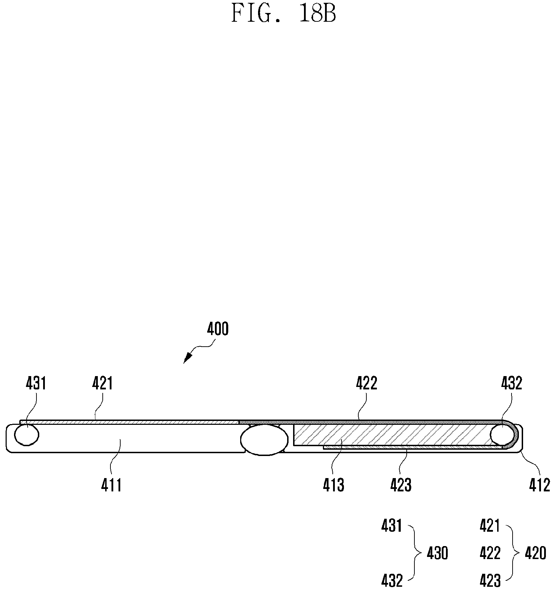

FIG. 18B is a cross-sectional view schematically illustrating an unfolded state (e.g., a second state) of the electronic device 400 having an out-folding structure and a sliding structure according to an embodiment.

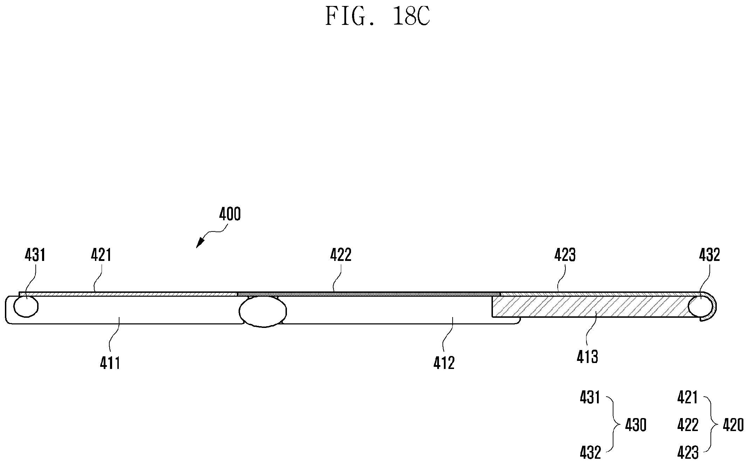

FIG. 18C is a cross-sectional view schematically illustrating an extended state (e.g., a third state) of the electronic device 400 having an out-folding structure and a sliding structure according to an embodiment.

Referring to FIGS. 18A to 18C, the electronic device 400 according to an embodiment may be an electronic device 400 having an out-folding structure and a sliding structure.

According to an embodiment, the electronic device 400 may include a first housing 411 and a second housing 412 that can be folded and unfolded. A flexible display 420 may be a single display extending from one surface of the first housing 411 to one surface of the second housing 412 via a hinge region. Some regions (e.g., a first region 421 and a second region 422) of the flexible display 420 may be disposed on the outer surface of each of the first housing 411 and the second housing 412, rather than on the inner surfaces of the first housing 411 and the second housing 412 facing each other while the electronic device 400 is folded. The remaining region (e.g., a third region 423) of the flexible display 420 may be disposed on the inner surfaces of the first housing 411 and second housing 412 facing each other while the electronic device 400 is folded.

A first roller 431 may be disposed inside the first housing 411 so as to insert one end of the flexible display 420 into the first housing 411 or withdraw one end of the flexible display 420 from inside the first housing 411.

A second roller 432 may be disposed inside the second housing 412 so as to insert the other end of the flexible display 420 into the second housing 412 or withdraw the other end of the flexible display 420 from inside the second housing 412.

The second housing 412 may include a sliding structure. According to an embodiment, the electronic device 400 may include a third housing 413 (or a slider) that is slidable with respect to the second housing 412. The third housing 413 may be configured to be slidable with respect to the second housing 412.

According to an embodiment, the flexible display 420 is a single display that extends from one surface of the first housing 411 to one surface of the second housing 412 via a hinge region, and may extend from one surface of the second housing 412 to the third housing 413.

FIG. 18A illustrates the folded state (e.g., the first state) of the electronic device 400 having an out-folding structure and a sliding structure according to an embodiment. According to an embodiment, the flexible display 420 may include the first region 421, the second region 422, and the third region 423, and in a folded state, either the first region 421 or the third region 423 may be disposed inside the housing and may not be visually exposed to the outside. FIG. 18A illustrates, as an example of the first state, a state in which the third region 423 of the flexible display 420 is disposed inside the second housing 412, and the first region 421 and second region 422 of the flexible display 420 are visually exposed to the outside. The electronic device 400, according to an embodiment illustrated in FIG. 18A, may configure the first region 421 or the second region 422 as a main display. The first state of the electronic device 400, according to an embodiment illustrated in FIG.18A, is a folded state, and may be defined as a "first folded state" in which the first region 421 and the second region 422 of the flexible display 420 are visually exposed to the outside.

FIG. 18B illustrates the unfolded state (e.g., the second state) of the electronic device 400 having an out-folding structure and a sliding structure according to an embodiment. According to an embodiment, in the unfolded state, either the first region 421 or the third region 423 of the flexible display 420 (e.g., the third region 423) may be disposed inside a housing, and thus may not be visually exposed to the outside. FIG. 18B illustrates, as an example of the second state, a state in which the third region 423 of the flexible display 420 is disposed inside the second housing 412, and the first region 421 and second region 422 of the flexible display 420 are visually exposed to the outside. The electronic device 400, according to an embodiment illustrated in FIG. 18B, may configure the first region 421 and the second region 422 as a main display. The second state of the electronic device 400, according to an embodiment illustrated in FIG. 18B, is an unfolded state, and may be defined as a "first unfolded state" in which the first region 421 and second region 422 of the flexible display 420 are configured as a main display.

FIG. 18C illustrates the extended state (e.g., the third state) of the electronic device 400 having an out-folding structure and a sliding structure according to an embodiment. According to an embodiment, in the extended state, a partial region (e.g., the first region 421) of the flexible display 420 disposed inside the first housing 411 or a region (e.g., the third region 423) of the flexible display 420 disposed inside the second housing 412 may be withdrawn from inside the housing to the outside. The electronic device 400, according to an embodiment illustrated in FIG. 18C, may configure the entire region of the flexible display 420, for example, the first region 421, the second region 422, and the third region 423, as a main display.

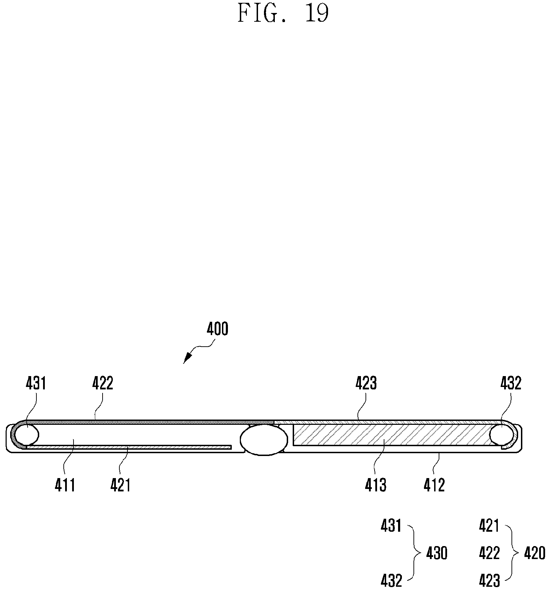

FIG. 19 is a cross-sectional view schematically illustrating a second unfolded state of the electronic device 400 having an out-folding structure and a sliding structure according to an embodiment.

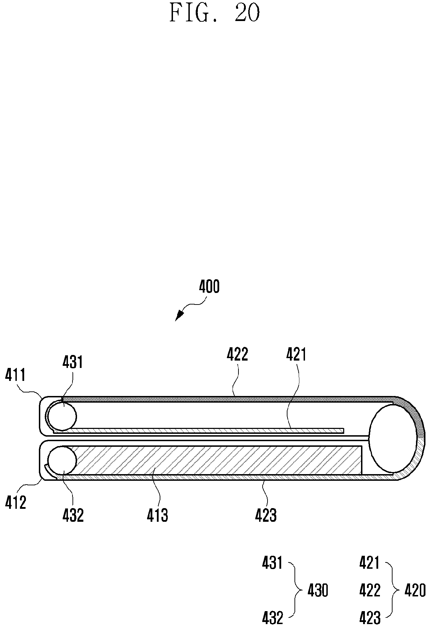

FIG. 20 is a cross-sectional view schematically illustrating a second folded state of the electronic device 400 having an out-folding structure and a sliding structure according to an embodiment.

Referring to FIG. 19, when switching from a third state (e.g., an extended state, see FIG. 18C) to a second state (e.g., an unfolded state, or a second unfolded state), the electronic device 400 having an out-folding structure and a sliding structure according to an embodiment may change some regions of the flexible display 420 that are driven as a main display. For example, as illustrated in FIG. 18B, the electronic device 400 may configure the first region 421 and the second region 422 as a main display. The electronic device 400 may switch from a state (e.g., an unfolded state) in which the first region 421 and the second region 422 are configured as the main display to the third state. For example, as illustrated in FIG. 19, when changing from the third state to the second state, the electronic device 400 may switch to a state (e.g., the second unfolding state) in which the second region and third region 423 are configured as the main display.

Referring to FIG. 20, when switching from the second state (e.g., the unfolded state or the second unfolded state) to a first state (e.g., a first folded state or a second folded state), the electronic device 400 having an out-folding structure and a sliding structure according to an embodiment may change some regions of the flexible display 420 that are visually exposed to the outside.

The electronic device 400 may switch from an unfolded state (e.g., FIG. 18B or FIG. 19) to a folded state, and may switch to the first folded state as illustrated in FIG. 18A, or to the second folded state as illustrated in FIG. 20. In terms of the external appearance, the second folded state of the electronic device 400 illustrated in FIG. 20 may be substantially the same as the first folded state illustrated in FIG. 18A. The second folded state of the electronic device 400 illustrated in FIG. 20 may differ from the first folded state illustrated in FIG. 18A in terms of some areas of the flexible display 420 that are visually exposed to the outside. For example, the first folded state illustrated in FIG. 18A is a state in which the first region 421 and the second region 422 of the flexible display 420 are visually exposed to the outside, wherein the first region 421 or the second region 422 may be configured as a main display. For example, the second folded state of the electronic device 400 illustrated in FIG. 20 is a state in which the second region 422 and the third region 423 of the flexible display 420 are visually exposed to the outside, wherein the second region 422 or the third region 423 may be configured as a main display.

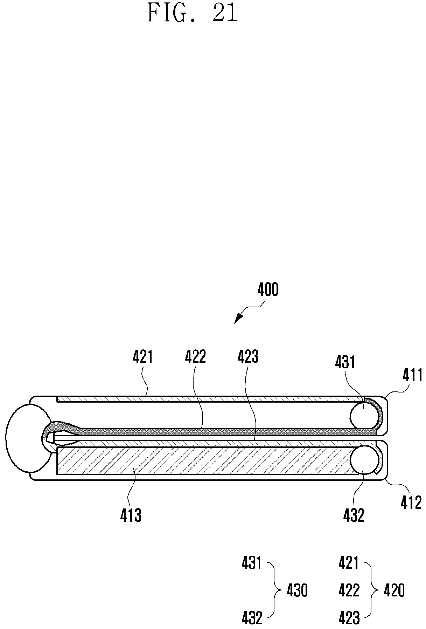

FIG. 21 is a cross-sectional view schematically illustrating a folded state of an electronic device 400 having an in-folding structure and a sliding structure according to an embodiment.

The electronic device 400 according to an embodiment illustrated in FIG. 21 differs from the electronic device 400 described with reference to FIGS. 18A to 20 in that, in the folded state, portions of a flexible display 420 may be disposed on the inner surfaces of the first housing 411 and the second housing 412 and face each other. Hereinafter, only configurational features that differ from those of the electronic device 400 described with reference to Figures 18A to 20 will be described.

The flexible display 420 of the electronic device 400 according to an embodiment may include a first region 421, a second region 422, and a third region 423. In the folded state, the first region 421 of the flexible display 420 may be visually exposed to the outside through a first surface of the first housing 411 and may be configured as a main display.

In the folded state, the second region 422 and the third region 423 may be disposed on a second surface of the first housing 411 opposite the first surface, and on a third surface of the second housing 412 facing the second surface, respectively.

In the folded state, the second region 422 and the third region 423 of the flexible display 420 may be disposed on the second surface of the first housing 411 and on the third surface of the second housing 412 facing the second surface, respectively, so that the second region 422 and the third region 423 of the flexible display 420 may be disposed on the inner surfaces of the first housing 411 and the second housing 412 so as to face each other, and may not visually exposed to the outside.

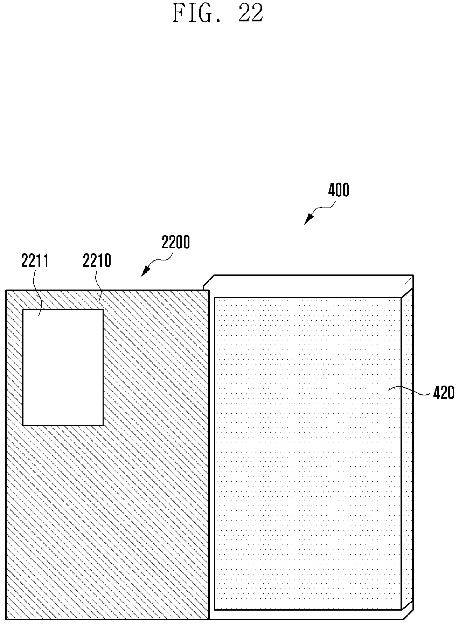

FIG. 22 illustrates a state in which an electronic device 400 having a sliding structure according to an embodiment is coupled to an accessory.

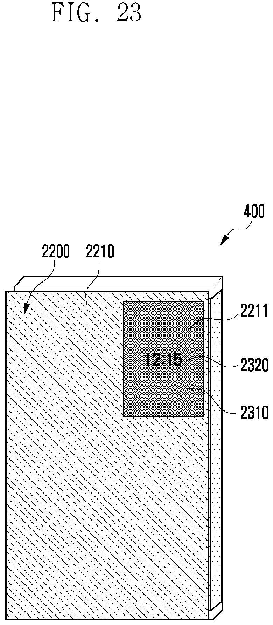

FIG. 23 illustrates a state in which a portion of an accessory 2200 covers a flexible display 420 while the electronic device 400 having a sliding structure according to an embodiment is coupled to the accessory.

Referring to FIGS. 22 and 23, the electronic device 400 having a sliding structure according to an embodiment may adjust the visible region of the flexible display 420 in conjunction with the movement of the accessory 2200 while the accessory 2200 is coupled.

According to an embodiment, the accessory 2200 may be configured to at least partially surround the exterior of the electronic device 400, and may include a window cover 2210 capable of covering the visible region of the flexible display 420. For example, the accessory 2200 may be a casing member configured to case the electronic device 400 having a sliding structure, and may include the window cover 2210 covering a portion of the flexible display 420 corresponding to a main display.

According to an embodiment, the window cover 2210 may include a transparent window 2211 configured to enable viewing of a portion of the main display.

According to an embodiment, the electronic device 400 may detect the accessory 2200. For example, the electronic device 400 may detect whether the window cover 2210 of the accessory 2200 covers a portion of the flexible display 420 while the accessory 2200 is coupled to the electronic device 400. In the disclosure, a state in which the window cover 2210 of the accessory 2200 covers a portion of the flexible display 420 corresponding to the main display is defined as a "closed state". In the disclosure, a state in which the window cover 2210 of the accessory 2200 does not cover the portion of the flexible display 420 corresponding to the main display is defined as a "open state" For example, the closed state may be a state in which the surface of the flexible display 420 and the window cover 2210 form an angle less than a designated angle, wherein the surface of the flexible display 420 and the window cover 2210 are substantially parallel. For example, the open state may be a state in which the surface of the flexible display 420 and the window cover 2210 form an angle greater than or equal to the designated angle.

According to an embodiment, when it is detected that the window cover 2210 of the accessory 2200 covers the flexible display 420, the electronic device 400 may determine that the electronic device 400 has switched from the open state to the closed state. The electronic device 400 may display a designated always-on display (AOD) screen 2320 through an AOD region 2310 of the flexible display 420 corresponding to the transparent window 2211 of the window cover 2210 in the closed state, wherein the remaining region, other than the AOD region 2310, may be configured to display a designated screen for reducing image quality deviation due to burn-in deviation. According to an embodiment, the designated AOD screen 2320 may include a calendar, a clock, a photo, or a designated screen configured by a user.

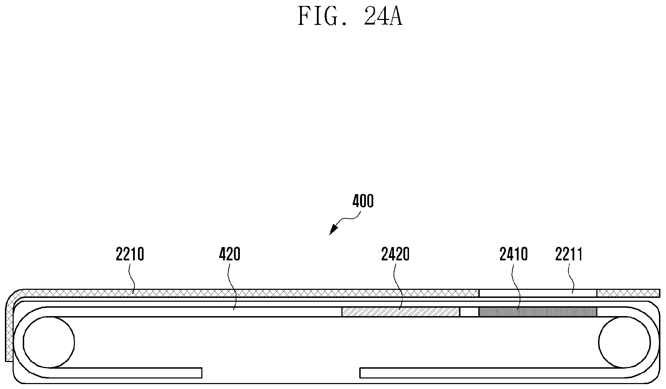

FIG. 24A illustrates a cross-section view of a flexible display 420 of an electronic device 400, which has a sliding structure according to an embodiment, in a first state when an accessory 2200 is covering the flexible display 420.

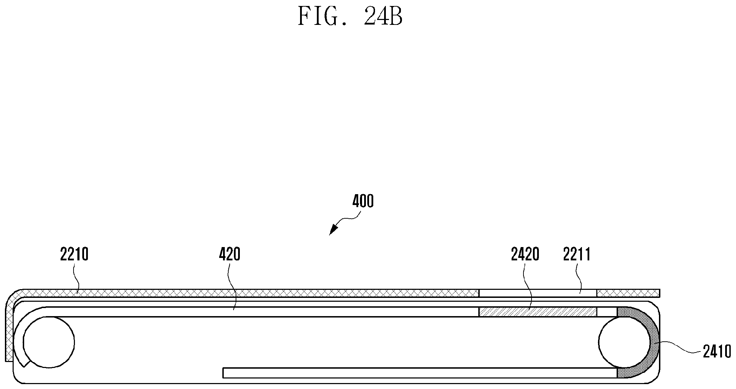

FIG. 24B illustrates a cross-section view of the flexible display 420 of the electronic device 400, which has a sliding structure according to an embodiment, in a second state when the accessory 2200 is covering the flexible display 420.

FIGS. 24A and 24B may examples of illustrating the closed state of the electronic device 400 according to an embodiment described with reference to FIGS. 22 and 23.

Referring to FIGS. 24A and 24B, the electronic device 400 having a sliding structure according to an embodiment may not fix a portion of the flexible display 420 which displays an AOD screen (e.g., the AOD screen 2320 in FIG. 23) when an accessory 2200 covers the flexible display 420.

According to an embodiment, each time a window cover 2210 is opened and closed, the electronic device 400 may change a portion of the flexible display 420 corresponding to a transparent window 2211 of a window cover 2210, thereby may change a portion of the flexible display 420 which displays an AOD screen (e.g., the AOD screen 2320 in FIG. 23). For example, as illustrated in FIG. 24A, when the flexible display 420 of the electronic device 400 is covered by the accessory 2200, the electronic device 400 may configure a first region 2410 of the flexible display 420 corresponding to the transparent window 2211 of the window cover 2210 to display an AOD screen (e.g., the AOD screen 2320 in FIG. 23). The electronic device 400 may detect an event in which the user opens and closes the window cover 2210 after the first region 2410 of the flexible display 420 displays the AOD screen 2320. In response to the event, the electronic device 400 may change from a state in which the first region 2410 of the flexible display 420 displays the AOD screen 2320 to a state in which a second region 2420 displays the AOD screen 2320, as illustrated in FIG. 24B.

In the illustrated examples, the first region 2410 of the flexible display 420 or the second region 2420 of the flexible display 420 displays the AOD screen 2320. However, the portion of the flexible display 420 for displaying the AOD screen 2320 is not limited thereto, and may change continuously over time of use without being fixed.

According to an embodiment, the electronic device 400 may not only change the portion of the flexible display 420 displaying the AOD screen 2320, each time the window cover 2210 is opened and closed, but may also change the portion of the flexible display 420 displaying the AOD screen 2320, even while the window cover 2210 is closed. For example, the electronic device 400 may count a time for which the first region 2410 of the flexible display 420 displays the AOD screen 2320. Even if there is no event to open and close the window cover 2210, the electronic device 400 may change the portion of the flexible display 420 displaying the AOD screen 2320 to a region other than the first region 2410 when the time exceeds a predetermined time. For example, the electronic device 400 may count a time for which the first region 2410 of the flexible display 420 displays the AOD screen 2320, and may configure the second region 2420 to display the AOD screen 2320 when the time exceeds a predetermined time. In this case, the electronic device 400 may configure the remaining regions of the flexible display 420, other than the second area 2420, to display a designated screen for reducing image quality degradation due to burn-in deviation.

According to an embodiment, the electronic device 400 may count a time for which the first region 2410 displays the AOD screen 2320 and output a notification (not shown) when the time exceeds a predetermined time. The notification may include a message that instructs a user to configure another region of the flexible display 420, other than the first area 2410 of the flexible display 420, as a region for displaying the AOD screen 2320 in order to reduce image quality deviation. For example, by checking the message, the user may input, to the electronic device 400, an event (e.g., a user input) for changing the portion of the flexible display 420 displaying the AOD screen 2320. The message may be in the form of text, for example, as illustrated in FIG. 17. However, the message is not limited thereto and may also be in a speech form and/or a vibration form.

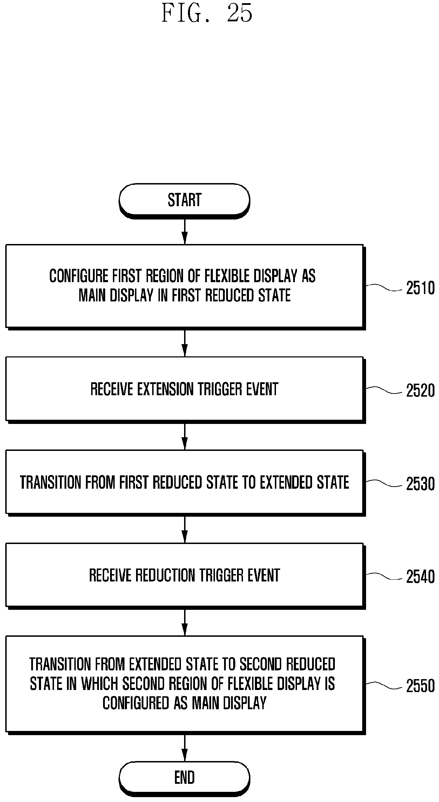

FIG. 25 is a flowchart illustrating operations of the electronic device 400 having a sliding structure according to an embodiment.

At least some of the operations illustrated in FIG. 25 may be omitted. Before or after at least some of the operations illustrated in FIG. 25, at least some operations described with reference to other drawings in the disclosure may be added.

The operations illustrated in FIG. 25 may be performed by a processor 120 (e.g., the processor 120 in FIG. 1). For example, a memory (e.g., the memory 130 in FIG. 1) of the electronic device 400 may store instructions that, when executed, cause the processor 120 to perform at least some of the operations illustrated in FIG. 25.

In operation 2510, the electronic device 400 according to an embodiment may configure the first region 421 of the flexible display 420 as a main display in a first reduced state. In the first reduced state, the first region 421 of the flexible display 420 may be disposed to face the front surface of the electronic device 400, and the second region 422 of the flexible display 420 may be disposed inside the second housing 412 and may not be visible from the outside. In the first reduced state, the first region 421 of the flexible display 420, as the main display, may form a first visible region VA1. For example, in the first reduced state, the area of the first visible region VA1 may be substantially equal to the area of the first region 421 of the flexible display 420

In operation 2520, the electronic device 400 may receive an extension trigger event in the first reduced state in which the first region 421 of the flexible display 420 is configured as the main display. The extension trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In operation 2530, the electronic device 400 according to an embodiment may switch from the first reduced state to an extended state based on the extension trigger event. In the extended state, the first region 421 and the second region 422 of the flexible display 420 may be disposed to face the front surface of the electronic device 400, thereby allowing the first region 421 and the second region 422 of the flexible display 420 to be visible from the outside. In the extended state, the first region 421 and the second region 422 of the flexible display 420, as the main display, may form a second visible region VA2. For example, the area of the second visible region VA2 corresponding to the extended state may be larger than the area of the first visible region VA1 corresponding to the first reduced state. According to an embodiment, the area of the second visible region VA2 corresponding to the extended state may be substantially equal to the sum of the area of the first region 421 and the area of the second region 422.

**In** operation 2540, the electronic device 400 according to an embodiment may receive a reduction trigger event in the extended state. The reduction trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

**In** operation 2550, the electronic device 400 according to an embodiment may switch from the extended state to a second reduced state based on the reduction trigger event. **In** terms of the external appearance of the electronic device 400, the second reduced state may be substantially the same as the first reduced state. The second reduced state may differ from the first reduced state in terms of a region of the flexible display 420 that forms a visible region. For example, the first reduced state is a state in which the first region 421 of the flexible display 420 forms the visible region, wherein the first region 421 of the flexible display 420 may function as a main display. The second reduced state may be a state in which the second region 422 of the flexible display 420 forms a visible region, or the second region 422 and a portion of the first region 421 of the flexible display 420 form a visible region, wherein the second region 422 of the flexible display 420 may function as a main display, or the second region 422 and a portion of the first region 421 of the flexible display 420 may function as a main display.

Although not illustrated, the electronic device 400 may switch into an extended state based on an extension trigger event after the second reduced state, and may switch from the extended state to the first reduced state when a reduction trigger event is received after the switching to the extended state.

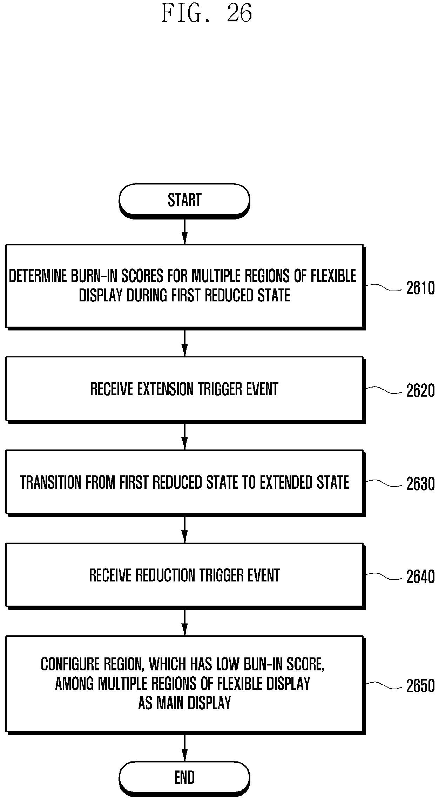

FIG. 26 is a flowchart illustrating operations of the electronic device 400 having a sliding structure according to an embodiment.

At least some of the operations illustrated in FIG. 26 may be omitted. Before or after at least some of the operations illustrated in FIG. 26, at least some operations described with reference to other drawings in this disclosure may be added.

The operations illustrated in FIG. 26 may be performed by a processor 120 (e.g., the processor 120 in FIG. 1). For example, a memory (e.g., the memory 130 in FIG. 1) of the electronic device 400 may store instructions that, when executed, cause the processor 120 to perform at least some of the operations illustrated in FIG. 26.

In operation 2610, the electronic device 400 according to an embodiment may determine, during a first reduced state, a first bum-in score indicative of the degree of burn-in of the first region 421 and a second burn-in score indicative of the degree of burn-in of the second region 422. The electronic device 400 according to an embodiment may determine a region, which has a lower burn-in score, among multiple regions of the flexible display 420. The electronic device 400 may determine the first burn-in score based on the cumulative result of the usage time of the first region 421 or the characteristics of images displayed through the first region 421. The electronic device 400 may determine the second burn-in score based on the cumulative result of the usage time of the second region 422 or the characteristics of images displayed through the second region 422. A relatively high burn-in score of a specific region may indicate that the specific region has experienced relatively more degradation and has a reduced lifespan. A relatively low burn-in score of a specific region may indicate that the particular area has experienced relatively less degradation and has a relatively increased lifespan. For example, when the first burn-in score corresponding to the first region 421 of the flexible display 420 is higher than the second burn-in score corresponding to the second region 422 of the flexible display 420, this may imply that the lifespan of the first region 421 is shorter than the lifespan of the second region 422. For example, when the first burn-in score corresponding to the first region 421 of the flexible display 420 is higher than the second burn-in score corresponding to the second region 422 of the flexible display 420, this may imply that the first region 421 has undergone more degradation than the second region 422.

In operation 2620, the electronic device 400 according to an embodiment may receive an extension trigger event during the first reduced state. The extension trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

**In** operation 2630, the electronic device 400 according to an embodiment may switch from the first reduced state to an extended state based on the extension trigger event. **In** the extended state, the first region 421 and the second region 422 of the flexible display 420 may be disposed to face the front surface of the electronic device 400, thereby allowing the first region 421 and the second region 422 of the flexible display 420 to be visible from the outside. In the extended state, the first region 421 and the second region 422 of the flexible display 420, as a main display, may form a second visible region VA2. For example, the area of the second visible region VA2 corresponding to the extended state may be larger than the area of a first visible region VA1 corresponding to the first reduced state. According to an embodiment, the area of the second visible region VA2 corresponding to the extended state may be substantially equal to the sum of the area of the first region 421 and the area of the second region 422.

In operation 2640, the electronic device 400 according to an embodiment may receive a reduction trigger event in the extended state. The reduction trigger event may include a user input via the flexible display 420, a user input via a physical button disposed on the periphery of the first housing 411, a user input via a physical button disposed on the periphery of the second housing 412, or a control signal (e.g., a remote-control signal) received from an external device via a communication module.

In operation 2650, the electronic device 400 according to an embodiment may switch from the extended state to a reduced state based on the reduction trigger event, and may determine that regions, which has low burn-in scores, among a plurality of regions of the flexible display 420 are some regions of the flexible display 420 which is to be displayed as a main display. The electronic device 400 may determine to switch from the extended state to the first reduced state or from the extended state to the second reduced state based on whether the first burn-in score is greater than or equal to the second burn-in score.

When the first burn-in score is greater than or equal to the second burn-in score, the electronic device 400 may switch from the extended state to the second reduced state in response to receiving the reduction trigger event after switching from the first reduced state to the extended state. For example, when the first burn-in score corresponding to the first region 421 of the flexible display 420 is higher than the second burn-in score corresponding to the second region 422 of the flexible display 420, the electronic device 400 may consider that the lifespan characteristic of the first region 421 is in a lower state (e.g., a worse state) than the lifespan characteristic of the second region 422, and may configure the second region 422 as a main display during the next reduced state.

When the first burn-in score is smaller than the second burn-in score, the electronic device 400 may switch from the extended state to the first reduced state in response to receiving the reduction trigger event after switching from the first reduced state to the extended state. For example, when the first burn-in score corresponding to the first region 421 of the flexible display 420 is lower than the second burn-in score corresponding to the second region 422 of the flexible display 420, the electronic device 400 may consider that the lifespan characteristic of the first region 421 is in a higher state (e.g., in a better state) than the lifespan characteristic of the second region 422, and may configure the first region 421 as a main display during the next reduced state.

An electronic device (e.g., the electronic device 400 in FIG. 7A) according to an embodiment may include a first housing (e.g., the first housing 411 in FIG. 7A), a second housing (e.g., the second housing 412 in FIG. 7A) disposed to slide with respect the first housing 411, a flexible display (e.g., the flexible display 420 in FIG. 7A) in which a visible region visible from outside the electronic device 400 is reduced or extended based on slide-in or slide-out driving of the second housing 412, a motor configured to generate a driving force for sliding the second housing 412, a driving circuit configured to drive the motor, and a processor (e.g., the processor 120 in FIG. 1), wherein the processor 120 is configured to: control the driving circuit such that a first region (e.g., the first region 421 in FIG. 7A) of the flexible display forms the first visible region in a first reduced state in which a portion of the second housing 412 slides into the first housing 411; switch, in response to an extension trigger event, from the first reduced state to an extended state in which the portion of the second housing 412 slides out from inside the first housing 411, wherein the extended state is a state in which the first region 421 of the flexible display and a second region (e.g., the second region 422 in FIG. 7A) of the flexible display form a second visible region, and the second region 422 is adjacent to the first region 421 and is disposed inside the second housing 412 during the first reduced state; and switch from the extended state to a second reduced state in response to a reduction trigger event, wherein the second reduced state is a state in which the second region 422 forms at least a portion of a third visible region.

According to an embodiment, the area of the third visible region formed by the second region 422 and a portion of the first region 421 of the flexible display may be equal to the area of the first visible region formed by the first region 421 of the flexible display.

According to an embodiment, the area of the second visible region may be equal to the sum of the area of the first region 421 and the area of the second region 422.

According to an embodiment, during the second reduced state, the remaining region of the first region 421, other than the portion of the first region 421 forming the visible region, may be disposed inside the first housing 411.

According to an embodiment, the processor 120 may be configured to: switch from the second reduced state to the extended state in response to the extension trigger event; and control the driving circuit such that switching from the extended state to the first reduced state is performed in response to receiving the reduction trigger event after switching from the second reduced state to the extended state.

According to an embodiment, the processor 120 may be configured to: determine, during the first reduced state, a first burn-in score indicative of the degree of burn-in of the first region 421 and a second burn-in score indicative of the degree of burn-in of the second region 422; and determine, based on whether the first burn-in score is greater than or equal to the second burn-in score, a switching from the extended state to the first reduced state or a switching from the extended state to the second reduced state.

According to an embodiment, the processor 120 may be configured to: when the first burn-in score is greater than or equal to the second burn-in score, control the driving circuit such that the switching from the extended state to the second reduced state is performed in response to receiving the reduction trigger event after switching from the first reduced state to the extended state; and when the first burn-in score is smaller than the second burn-in score, control the driving circuit such that the switching from the extended state to the first reduced state is performed in response to receiving the reduction trigger event after switching from the first reduced state to the extended state.

According to an embodiment, the processor 120 may be configured to: determine the first burn-in score based on a cumulative result of a usage time of the first region 421 or characteristics of images displayed through the first region 421; and determine the second burn-in score based on a cumulative result of a usage time of the second region 422 or characteristics of images displayed through the second region 422.

According to an embodiment, the processor 120 may be configured to: during the first reduced state, display a designated screen through the second region 422 of the flexible display; and configure the luminance of the designated screen to decrease linearly at a boundary portion of the second region 422 adjacent to the first region 421.

According to an embodiment, the processor 120 may be configured to: configure the luminance of the designated screen displayed through the boundary portion of the second region 422 to be higher with decreasing distance to the first region 421; and configure the luminance of the designated screen displayed through the boundary portion of the second region 422 to be lower with increasing distance from the first region 421.

According to an embodiment, the processor 120 may be configured to: detect an accessory configured to at least partially surround the exterior of the electronic device 400 and including a window cover capable of covering the visible region of the flexible display; display an always-on display (AOD) screen through an AOD region of the flexible display corresponding to a window of the window cover when the window cover of the accessory is detected to cover the flexible display, wherein the remaining region, other than the region displaying the AOD screen, is configured to display a designated screen; configure a portion of the first region 421 to display the AOD screen during the first reduced state; and configure a portion of the second region 422 to display the AOD screen during the second reduced state.

In a method performed by an electronic device 400 according to an embodiment, the electronic device 400 may include a first housing 411, a second housing 412 disposed to slide with respect the first housing 411, a flexible display 420 in which a visible region visible from outside the electronic device 400 is reduced or extended based on slide-in or slide-out driving of the second housing 412, a motor configured to generate a driving force for sliding the second housing 412, and a driving circuit configured to drive the motor. The method may include: controlling the driving circuit such that a first region 421 of the flexible display forms the first visible region in a first reduced state in which a portion of the second housing 412 slides into the first housing 411; switching, in response to an extension trigger event, from the first reduced state to an extended state in which the portion of the second housing 412 slides out from inside the first housing 411, wherein the extended state is a state in which the first region 421 of the flexible display and a second region 422 of the flexible display form a second visible region, and the second region 422 is adjacent to the first region 421 and is disposed inside the second housing 412 during the first reduced state; and switching from the extended state to a second reduced state in response to a reduction trigger event, wherein the second reduced state is a state in which the second region 422 forms at least a portion of a third visible region.

According to an embodiment, the area of the third visible region formed by the second region 422 and a portion of the first region 421 of the flexible display may be equal to the area of the first visible region formed by the first region 421 of the flexible display.

According to an embodiment, the area of the second visible region may be equal to the sum of the area of the first region 421 and the area of the second region 422.

According to an embodiment, during the second reduced state, the remaining region of the first region 421, other than the portion of the first region 421 forming the visible region, may be disposed inside the first housing 411.

According to an embodiment, the method may include switching from the second reduced state to the extended state in response to the extension trigger event; and controlling the driving circuit such that switching from the extended state to the first reduced state is performed in response to receiving the reduction trigger event after switching from the second reduced state to the extended state.

According to an embodiment, the method may include determining, during the first reduced state, a first burn-in score indicative of the degree of burn-in of the first region 421 and a second burn-in score indicative of the degree of burn-in of the second region 422; and determining, based on whether the first burn-in score is greater than or equal to the second burn-in score, a switching from the extended state to the first reduced state or a switching from the extended state to the second reduced state.

According to an embodiment, the method may include: when the first burn-in score is greater than or equal to the second burn-in score, controlling the driving circuit such that the switching from the extended state to the second reduced state is performed in response to receiving the reduction trigger event after switching from the first reduced state to the extended state; and when the first burn-in score is smaller than the second burn-in score, controlling the driving circuit such that the switching from the extended state to the first reduced state is performed in response to receiving the reduction trigger event after switching from the first reduced state to the extended state.

According to an embodiment, the method may include determining the first burn-in score based on a cumulative result of a usage time of the first region 421 or characteristics of images displayed through the first region 421; and determining the second burn-in score based on a cumulative result of a usage time of the second region 422 or characteristics of images displayed through the second region 422.

According to an embodiment, the method may include, during the first reduced state, displaying a designated screen through the second region 422 of the flexible display, and configuring the luminance of the designated screen to decrease linearly at a boundary portion of the second region 422 adjacent to the first region 421.

## Claims

1. An electronic device comprising:
a first housing;
a second housing disposed to slide with respect the first housing;
a flexible display in which a visible region visible from outside the electronic device is reduced or extended based on slide-in or slide-out driving of the second housing;
a driving unit configured to generate a driving force for sliding the second housing; and
a processor,
wherein the processor is configured to:
control the driving unit such that a first region of the flexible display is shown as a first visible region in a first reduced state in which a portion of the second housing slides into the first housing;
switch, in response to an extension trigger event, from the first reduced state to an extended state in which the portion of the second housing slides out from inside the first housing, the extended state being a state in which the first region of the flexible display and a second region of the flexible display are shown as a second visible region, and the second region being adjacent to the first region and disposed inside the second housing during the first reduced state; and
switch from the extended state to a second reduced state in response to a reduction trigger event, the second reduced state being a state in which the second region is shown as at least a portion of a third visible region.

2. The electronic device of claim 1, wherein the area of the third visible region shown by a portion of the first region and the second region of the flexible display is equal to the area of the first visible region shown by the first region of the flexible display.

3. The electronic device of claim 1, wherein the area of the second visible region is equal to the sum of the area of the first region and the area of the second region.

4. The electronic device of claim 1, wherein, during the second reduced state, the remaining region of the first region, other than the portion of the first region forming the third visible region, is disposed inside the first housing.

5. The electronic device of one of claims 1 to 4, wherein the processor is configured to:
switch from the second reduced state to the extended state in response to the extension trigger event; and
control the driving unit such that switching from the extended state to the first reduced state is performed in response to receiving the reduction trigger event after switching from the second reduced state to the extended state.

6. The electronic device of one of claims 1 to 4, wherein the processor is configured to:
determine, during the first reduced state, a first burn-in score indicative of the degree of burn-in of the first region and a second burn-in score indicative of the degree of burn-in of the second region; and
determine, based on whether the first burn-in score is greater than or equal to the second burn-in score, a switching from the extended state to the first reduced state or a switching from the extended state to the second reduced state.

7. The electronic device of claim 6, wherein the processor is configured to:
in case that the first burn-in score is greater than or equal to the second burn-in score, control the driving unit such that the switching from the extended state to the second reduced state is performed in response to receiving the reduction trigger event after switching from the first reduced state to the extended state; and
in case that the first burn-in score is smaller than the second burn-in score, control the driving unit such that the switching from the extended state to the first reduced state is performed in response to receiving the reduction trigger event after switching from the first reduced state to the extended state.

8. The electronic device of claim 6, wherein the processor is configured to:
determine the first burn-in score based on a cumulative result of a usage time of the first region or characteristics of images displayed through the first region; and
determine the second burn-in score based on a cumulative result of a usage time of the second region or characteristics of images displayed through the second region.

9. The electronic device of claim 1, wherein the processor is configured to:
during the first reduced state,
display a designated screen through the second region of the flexible display; and
configure luminance of the designated screen to decrease linearly at a boundary portion of the second region adjacent to the first region.

10. The electronic device of claim 9, wherein the processor is configured to:
configure the luminance of the designated screen displayed through the boundary portion of the second region to be higher with decreasing distance to the first region; and
configure the luminance of the designated screen displayed through the boundary portion of the second region to be lower with increasing distance from the first region.

11. The electronic device of claim 1, wherein the processor is configured to:
detect an accessory configured to at least partially surround the exterior of the electronic device and comprising a window cover capable of covering the visible region of the flexible display;
display an always-on display (AOD) screen through an AOD region of the flexible display corresponding to a window of the window cover in case that the window cover of the accessory is detected to cover the flexible display, wherein the remaining region, other than the region displaying the AOD screen, is configured to display a designated screen;
configure a portion of the first region to display the AOD screen during the first reduced state; and
configure a portion of the second region to display the AOD screen during the second reduced state.

12. A method performed by an electronic device, wherein the electronic device comprises:
a first housing;
a second housing disposed to slide with respect the first housing;
a flexible display in which a visible region visible from outside the electronic device is reduced or extended based on slide-in or slide-out driving of the second housing; and
a driving unit configured to generate a driving force for sliding the second housing, and
wherein the method comprises:
controlling the driving unit such that a first region of the flexible display is shown as a first visible region in a first reduced state in which a portion of the second housing slides into the first housing;
switching, in response to an extension trigger event, from the first reduced state to an extended state in which the portion of the second housing slides out from inside the first housing, the extended state being a state in which the first region of the flexible display and a second region of the flexible display are shown as a second visible region, and the second region being adjacent to the first region and disposed inside the second housing during the first reduced state; and
switching from the extended state to a second reduced state in response to a reduction trigger event, the second reduced state being a state in which the second region is shown as at least a portion of a third visible region.

13. The method of claim 12, wherein the area of the third visible region shown by a portion of the first region and the second region of the flexible display is equal to the area of the first visible region shown by the first region of the flexible display, and
wherein the area of the second visible region is equal to the sum of the area of the first region and the area of the second region.

14. The method of claim 12, wherein during the second reduced state, the remaining region of the first region, other than the portion of the first region forming the third visible region, is disposed inside the first housing.

15. The method of one of claims 12 to 14, comprising:
switching from the second reduced state to the extended state in response to the extension trigger event; and
controlling the driving unit such that switching from the extended state to the first reduced state is performed in response to receiving the reduction trigger event after switching from the second reduced state to the extended state.
